# EUROPEAN PATENT SPECIFICATION

(11) **EP 2 926 994 B1**
(45) Date of publication and mention of the grant of the patent: **27.03.2019**
(21) Application number: 15163053.0
(22) Date of filing: 06.05.2013
(51) Int. Cl.: B41N 1/08, G03F 7/09, B41C 1/10

(54) **LITHOGRAPHIC PRINTING PLATE COMPRISING A LAMINATED SUBSTRATE**
LITHOGRAFISCHE DRUCKPLATTE, UMFASSEND EIN LAMINIERTES SUBSTRAT
PLAQUE D'IMPRESSION LITHOGRAPHIQUE COMPRENANT UN SUBSTRAT STRATIFIÉ

(30) Priority: 10.04.2013 US 201361810303 P
(43) Date of publication of application: 07.10.2015
(62) Divisional of application: 13166715.6
(73) Proprietor: Mylan Group, Viet Nam (VN)
(72) Inventor: Nguyen, My, T., Travinh City (VN); Dang, Thuong T., Travinh City (VN); Phan, Khai N., Travinh City (VN)
(74) Representative: Jolly, Christophe

(56) References cited:
- WO-A1-93/10979
- US-A- 4 092 925
- US-A1- 2011 277 653

## Description

### FIELD OF THE INVENTION

The present invention relates to lithographic printing plates comprising a laminated substrate. More specifically, the present invention is concerned with such printing plates where the laminated substrate can be delaminated in view of recycling.

### BACKGROUND OF THE INVENTION

In lithographic printing, a printing plate is mounted on the cylinder of a printing press (typically using clamps on two opposite sides of the printing plate). The printing plate carries a lithographic image on its surface and a printed copy is obtained by applying ink to the image and then transferring the ink from the printing plate onto a receiver material, which is typically a sheet of paper. Generally, the ink is first transferred to an intermediate blanket, which in turn transfers the ink to the surface of the receiver material (offset printing).

In conventional, so-called "wet" lithographic printing, inks as well as an aqueous fountain solution (also called dampening liquid) are supplied to the lithographic image which consists of oleophilic/hydrophobic (i.e. ink-accepting, water-repelling) areas as well as hydrophilic/oleophobic (i.e. water-accepting, ink-repelling) areas. When the surface of the printing plate is moistened with the fountain solution and ink is applied, the hydrophilic regions retain the fountain solution and repel the ink, and the ink-receptive regions accept the ink and repel the fountain solution. During printing, the ink is transferred to the surface of the receiver material upon which the image is to be reproduced.

Lithographic printing plates typically comprise one or more imageable layers (also called imaging forming layer or imaging coating) applied over the hydrophilic surface of a substrate, typically aluminum treated to become hydrophilic. The imageable layer includes one or more radiation-sensitive components, often dispersed in a suitable binder. The image forming layer is sometimes covered by an overcoat layer.

To produce the lithographic image on the printing plate, the printing plate is imaged by targeted radiation. This can be carried out in different ways. In direct digital imaging (computer-to-plate), printing plates can be imaged with infrared or UV lasers (or light sources). Such a laser or light source can be digitally controlled via a computer; i.e. the laser can be turned on or off so that imagewise exposure of the precursor can be affected via stored digitized information in the computer. Therefore, the imageable layers of printing plates, which are to be imagewise exposed by means of such image-setters, need to be sensitive to radiation in the near-infrared or UV regions of the spectrum.

The imaging device will thus etch the image on the printing plate by eliciting a localized transformation of the imageable layer. Indeed, in such systems, the imageable layer typically contains a dye or pigment that absorbs the incident radiation and the absorbed energy initiates the reaction producing the image. Exposure to the imaging radiation triggers a physical or chemical process in the imageable layer so that the imaged areas become different from the non-imaged areas and development will produce an image on the printing plate. The change in the imageable layer can be a change of hydrophilicity/oleophilicity, solubility, hardness, etc.

Following exposure, either the exposed regions or the unexposed regions of the imageable layer are removed by a suitable developer, revealing the underlying hydrophilic surface of the substrate. Developers are typically aqueous alkaline solutions, which may also contain organic solvents. Developers can also be aqueous acidic solutions.

Alternatively, "on-press developable" or "processless" lithographic printing plate can be directly mounted on a press after imaging, and are developed through contact with ink and/or fountain solution during initial press operation. In other words, either the exposed regions or the unexposed regions of the imageable layer are removed by the ink and/or fountain solution, not by a developer. More specifically, a so-called on-press development system is one in which an exposed printing plate is fixed on the plate cylinder of a printing press, and a fountain solution and ink are fed thereto while revolving the cylinder to remove the undesired areas. This technique allows an imaged, but un-developed printing plate (also called a printing plate precursor) to be mounted as is on a press and be made into a developed printing plate on an ordinary printing line.

In any case, if the exposed regions are removed, the precursor is positive-working. Conversely, if the unexposed regions are removed, the precursor is negative-working. In each instance, the regions of the imageable layer (i.e., the image areas) that remain are ink-receptive, and the regions of the hydrophilic surface revealed by the developing process accept water and aqueous solutions, typically a fountain solution, and do not accept ink.

The image on lithographic printing plate can also be produced using laser or inkjet printers.

For a long time, aluminum has been the substrate of choice for manufacturing of lithographic offset printing plates. This is due to its flexibility, durability on press and its recyclability (as scrap metal) after usage. The ever higher aluminum and energy costs have now however intensified a need in the industry for replacement substrates, which would reduce the cost of lithographic printing plate production.

When aluminum is used as a substrate, it is typically treated to produce a generally rough and hydrophilic aluminum oxide layer at its surface. This improves adhesion of the imaging layer and other layers that may constitute the printing plate. This also provides the hydrophilic/oleophobic (water-accepting, ink-repelling) areas on the developed printing plate.

Various others substrates are also known, including substrates made of aluminum foil laminated on a plastic or paper base layer. However, these can de-laminate upon use on press and are thus generally useful only for short run printing. More importantly, these substrates are not readily recyclable, which prevented their wide acceptance in the industry.

Also, polymeric substrates on which an imaging layer is deposited are known in the art. Again, these are generally useful only for short run printing. In addition, such substrates have a tendency to stretch upon use, which causes distortion of the printed image. However, these substrates are generally recyclable.

Printing plates generally have a tendency to stick to one another when stacked (for storage or use). To prevent this undesirable phenomenon, sheets of interleaving paper is typically placed in-between the plates. This increases the handling cost as the interleaving paper has to be removed for the plates to be loaded on a printing press. Similarly, it is noted that it is very difficult to cut a stack of printing plates to size without using interleaving paper.

The document US4095925 discloses a lithographic printing plate system utilizing a composite plate having an aluminium printing member having a light-sensitive coating thereon.

### SUMMARY

In accordance with the present disclosure, there is provided:
1. A laminated lithographic printing plate comprising:
   an aluminum layer having a first side and a second side,
   a first aluminum oxide layer coating the first side of the aluminum layer,
   optionally a second aluminum oxide layer coating the second side of the aluminum layer, an image forming layer coating the first aluminum oxide layer,
   an adhesive layer adhering to the second side of the aluminum layer or to said second aluminum oxide layer when said second aluminum oxide layer is present, and
   a base layer coating the adhesive layer,
   the adhesive layer being accessible to and insoluble in oleophilic inks and alkaline or acidic aqueous fountain solutions used during printing with the printing plate, and alkaline or acidic aqueous developers used during development of the printing plate, and
   the adhesive layer being:
   soluble in an alkaline aqueous processing liquid, when said developers and said fountain solutions are acidic,
   soluble in an acidic aqueous processing liquid, when said developers and said fountain solutions are alkaline,
   meltable, or
   when said second aluminum oxide layer is present, a dry adhesive compliant layer having a hardness of 60 Shore-A or less,
   thereby allowing delamination of the printing plate.
2. The printing plate of item 1, wherein the adhesive layer is soluble in an alkaline aqueous processing liquid.
3. The printing plate of item 2, wherein the adhesive layer comprises a drying adhesive comprising a polymer having a Tg between about 10 and 60°C and comprising polar functional groups and acidic functional groups.
4. The printing plate of item 3, wherein the polymer is an acrylate copolymer.
5. The printing plate of item 4, wherein the polymer is a copolymer of acrylic acid and one or more alkyl acrylate.
6. The printing plate of item 5, wherein the polymer is a copolymer of acrylic acid, methyl acrylate, and ethyl acrylate.
7. The printing plate of item 6, wherein the copolymer of acrylic acid, methyl acrylate, and ethyl acrylate comprises between about 5 and about 15% by weight methyl acrylate, between about 50 and about 80% by weight ethyl acrylate, and between about 5 and about 20% by weight acrylic acid.
8. The printing plate of item 1, wherein the adhesive layer is soluble in an acidic aqueous processing liquid.
9. The printing plate of item 8, wherein the adhesive layer comprises a drying adhesive comprising a polymer having a Tg between about 10 and 60°C and comprising polar functional groups and basic functional groups.
10. The printing plate of item 9, wherein the polymer is an acrylate copolymer.
11. The printing plate of item 10, wherein the polymer is a copolymer of dialkylamino alkyl acrylate and one or alkyl acrylate.
12. The printing plate of item 11, wherein the polymer is a copolymer of dimethyl amino ethyl acrylate, methyl acrylate, and ethyl acrylate.
13. The printing plate of item 12, wherein the copolymer of acrylic acid, methyl acrylate, and ethyl acrylate comprises between about 5 and about 15% by weight methyl acrylate, between about 50 and about 80% by weight ethyl acrylate, and between about 5 and about 20% by weight dimethyl amino ethyl acrylate.
14. The printing plate of item 1, wherein the adhesive layer is meltable.
15. The printing plate of item 14, wherein the adhesive layer comprises an ethylene-vinylacetate polymeric hot-melt adhesive, a polyamide hot-melt adhesive, a polyolefin hot-melt adhesive, a reactive polyurethane hot-melt adhesive, or an ethylene-acrylic ester-maleic anhydride terpolymer hot-melt adhesive.
16. The printing plate of item 1, wherein the adhesive layer is said dry adhesive compliant layer.
17. The printing plate of item 16, wherein the dry adhesive compliant layer comprises a thermoplastic polymer, a thermoplastic elastomer, or a crosslinked elastomer.
18. The printing plate of item 17, wherein the dry adhesive compliant layer comprises natural polyisoprene, synthethic polyisoprene, polybutadiene, polychloroprene, butyl rubber, styrene-butadiene rubber, nitrile rubber, ethylene propylene rubber, epichlorohydrin rubber, polyacrylic rubber, silicone rubber, fluorosilicone rubber, fluoroelastomers, perfluoroelastomers, polyether block amides, chlorosulfonated polyethylene, a ethylene-butadiene copolymer elastomer, ethylene-vinyl acetate, a silicone elastomer, a polyurethane elastomer, an aminopropyl terminated siloxane dimethyl polymer, a styrene-ethylene/propylene-styrene (SEPS) thermoplastic elastomer, a styrene-ethylene/butylene-styrene (SEBS) thermoplastic elastomer, a styrene-isoprene-styrene (SIS) thermoplastic elastomer, a styrene-butadiene-styrene (SBS) thermoplastic elastomer, or a styrene-ethylene/butylene-styrene grafted with maleic anhydride thermoplastic elastomer.
19. The printing plate of any one of items 1 to 18 further comprising a silicon release layer between the base layer and the adhesive layer.
20. The printing plate of any one of items 1 to 19, wherein the aluminum layer has a thickness between about 20 µm and about 200 µm.
21. The printing plate of any one of items 1 to 20, wherein the base layer is made of a recyclable material.
22. The printing plate of any one of items 1 to 21, wherein the base layer is a plastic layer, a composite layer, a cellulose-based layer such as cardstock or paper, or a non-woven fabric layer.
23. The printing plate of item 22, wherein the base layer comprises a thermoplastic resin.
24. The printing plate of items 23, wherein the base layer comprises:
   - polystyrene (PS),
   - a polyolefin such as polyethylene (PE) and polypropylene (PP) (including oriented PP, such biaxially oriented PP (or BOPP)),
   - a polyester, such as polyethylene terephthlate (PET),
   - polyamide (PA),
   - polyvinyl chloride (PVC),
   - polyetheretherketone (PEEK),
   - polyimide (PI),
   - polyvinylacetate (PVA),
   - polyalkylacrylate (PAAA),
   - polyalkylmethacrylate (PAMA),
   - polylactide,
   - polybutahydroburate,
   - polysuccinamate,
   - a cellulosic polymers,
   a copolymer thereof or a mixture thereof.
25. The printing plate of items 24, wherein the base layer is a PET film, a BOPP film, or a PP film.
26. The printing plate of any one of items 1 to 25, wherein the base layer comprises one or more filler.
27. The printing plate of items 26, wherein the filler is an inorganic filler, such as calcium carbonate, silica, alumina, titanium oxide, aluminosilicate, zeolite and fiberglass.
28. The printing plate of items 26, wherein the filler is an organic carbohydrate flour.
29. The printing plate of items 26, wherein the filler is carbon black.
30. The printing plate of items 1 to 27, wherein the base layer is a PP comprising 20 % of calcium carbonate.
31. The printing plate of any one of items 1 to 30, wherein the base layer has a thickness between about 10 and about 350 µm.
32. The printing plate of any one of items 1 to 31, further comprising an overcoat layer on the image forming layer.
33. The printing plate of any one of items 1 to 32, further comprising a second image forming layer on said image forming layer.

### BRIEF DESCRIPTION OF THE DRAWINGS

In the appended drawings:
Figure 1 is a cross-sectional scheme of an embodiment of a lithographic printing plate according to the disclosure;
Figure 2 is a cross-sectional scheme of an embodiment of a lithographic printing plate in which a release layer is present;
Figure 3 is a cross-sectional scheme of an embodiment of a lithographic printing plate in which a dry adhesive is used;
Figure 4 shows the manufacturing of an embodiment of a lithographic printing plate according to the disclosure in which the adhesive layer is produced by extrusion;
Figure 5 is shows the manufacturing of an embodiment of a lithographic printing plate according to the disclosure in which the adhesive layer is coated; and
Figure 6 is shows the manufacturing of an embodiment of a lithographic printing plate according to the disclosure in which a dry adhesive is used.

### DETAILED DESCRIPTION

### Printing Plates

The conventional substrate of choice for lithographic printing plate is an (expensive) aluminum sheet, typically of a thickness is between about 100 and 600 µm. The present disclosure arises from efforts of the inventors to produce a lithographic printing plate that is recyclable as well as potentially less expensive than its conventional counterparts.

The inventors endeavoured to replace the conventionally used aluminum sheet with a laminated substrate comprising a base layer covered by a typically thinner (and thus less expensive) aluminum sheet. The inventors also endeavoured to render this laminated substrate recyclable, which means that it can be delaminated (after use of the printing plate) allowing for the separate recycling of the base layer and the aluminum layer.

The inventors have previously proposed such a laminated substrate in US patent publication no. 2011/0277653. This substrate comprised (a) a base layer, (b) a layer of a adhesive covering one side of the base layer except for at least two opposite edges thereof, and (c) an aluminum layer laminated onto the layer of adhesive and said opposite edges of the base layer, the aluminum layer thereby being sealed with the base layer at said opposite edges of the base layer. Once formed, this substrate would be subjected to known processes to produce a printing plate (i.e. produce an aluminum oxide layer and an imaging layer). In recyclable embodiments of this substrate, the adhesive was soluble or dispersible in a processing liquid (typically water or a water-based solution, such as an alcohol-water mixture) used to delaminate the substrate. However, this meant that the adhesive would also be soluble in many of the various liquids used to prepare the aluminum oxide layer and the imaging layer on the substrate as well as the inks, fountain solutions and/or developers used when developing and printing. This is why a seal was provided between the aluminum layer and base layer at the opposite edges of the base layer. In embodiments, this seal was provided by strips of a secondary adhesive with different solubility characteristics. This seal prevented the layer of (the first) adhesive from contacting these various liquids and thus reduced the risks of delamination of the substrate. The presence of this seal meant however that the substrate would not delaminate in the processing liquid (the sealed edges keeping base layer attached to the aluminum layer even after dissolution/dispersion of the first adhesive). Therefore, prior to delamination, the spent printing plate had to be cut into flakes, which would then delaminate in the processing liquid.

The present inventors endeavoured to improve on the above. They wanted to eliminate the need for a seal (and strips of secondary adhesive), ease the manufacturing process so that it can be integrated into existing printing plate production lines, and ease the recycling of the printing plate, notably by removing the need to cut the used printing plates into flakes. Of course, the laminated substrate would still need not to delaminate during production and use of the printing plates and to readily delaminate in view of recycling.

Turning now to the present disclosure in more details, there is provided a laminated lithographic printing plate comprising:
an aluminum layer having a first side and a second side,
a first aluminum oxide layer coating the first side of the aluminum layer,
optionally a second aluminum oxide layer coating the second side of the aluminum layer, an image forming layer coating the first aluminum oxide layer,
an adhesive layer adhering to the second side of the aluminum layer or to said second aluminum oxide layer when the second aluminum oxide layer is present, and
a base layer coating the adhesive layer,
the adhesive layer being accessible to and insoluble in oleophilic inks and alkaline or acidic aqueous fountain solutions used during printing with the printing plate, and alkaline or acidic aqueous developers used during development of the printing plate, and
the adhesive layer being:
soluble in an alkaline aqueous processing liquid, when said developers and said fountain solutions are acidic,
soluble in an acidic aqueous processing liquid, when said developers and said fountain solutions are alkaline,
meltable, or
when said second aluminum oxide layer is present, a dry adhesive compliant layer having a hardness of 60 Shore-A or less,
thereby allowing delamination of the printing plate in view of recycling after printing.

Generally, the printing plate of the disclosure will have a total thickness between 100 µm and 600 µm, preferably between 100 and 400 µm.

### The Aluminum Layer, the First Aluminum Oxide Layer and the Image Forming Layer

Together, the aluminum layer, the first aluminum oxide layer and the image forming layer embody a rather conventional lithographic printing plate.

However, the aluminum layer can be thinner than in conventional printing plates because the base layer provides structural support to the printing plates of the present disclosure. For example, in embodiments of the present disclosure, the aluminum layer is between about 20 and about 300 µm thick, preferably between about 20 and about 200 µm thick. However, the aluminum may also be thicker, such as between about 100 and about 300 µm thick. The hardness of the aluminium layer is typical of that in conventional plates. For example, it can be between H16 and H18.

The first aluminum oxide layer is hydrophilic and thus provides a base for the coating of an imaging layer. The aluminum oxide layer can be produced by treating the aluminum layer as known in the art. Indeed, as stated above, aluminum substrates of the prior art are typically treated to form an aluminum oxide layer on their surfaces to make their more hydrophilic. It should be noted that the second aluminum oxide layer is of the same nature and made in the same manner as the first oxide layer. It is made in the same manner. However, it serves a different purpose as will be described below.

To improve printing performances, the hydrophilicity of the first aluminum oxide layer may be enhanced by processes known to the skilled person. For example, the aluminum oxide layer may be treated with organic and inorganic hydrophilic agents. The organic hydrophilic agents may be, for example, watersoluble polymers, copolymers, dendrimers or oligomers comprising phosphoric acid, carboxylic acid, sulfonic acid, or sulfuric acid functional groups. The inorganic hydrophilic agents may be, for example, aqueous solutions of sodium silicate, potassium silicates, and mixture of sodium dihydrophosphate and sodium fluoride.

In embodiments, the aluminum oxide layer has a roughness between about 0.1 and about 1.0 µm.

As in conventional lithographic printing plates, the aluminum oxide layer is coated with the one or more layers necessary to produce and print an image as is known in the art. This would typically include an image forming layer. This image forming layer is optionally covered by another image forming layer or by an overcoat layer. Generally, any suitable under-layers, image forming layers, overcoat layers and the like known the person skilled in the art of producing lithographic printing plates may be used in the present disclosure.

An image forming layer is a layer that is sensitive to radiation (typically a laser) and allows recording, developing and printing an image with the printing plate. In embodiments, the imaging layer is positive working. In other embodiments, the imaging layer is negative working. Any imaging layer known to the skilled person to be useful for the producing of lithographic printing plate may be used with in the lithographic printing plates of the disclosure. More specifically, the imaging layer may be an imaging layer for positive working lithographic printing plates of this disclosure as taught in US patents no. 6,124,425; US 6,177,182; and US 7,473,515. The imaging layer may also be an imaging layer for negative working lithographic printing plates as taught in US patent publications no. 2007/0269739; US 2008/0171286; US 2010/0035183 and US 2010/0062370. A typical image forming layer may have a thickness between about 0.5 and about 5 µm.

In embodiments, the image forming layer is coated with an overcoat layer. Suitable overcoat layers are known to the skilled person. These may have different roles such as protecting the imaging layer from ambient light or humidity, reducing the stickiness of the printing plate, etc. In embodiments, the overcoat layer may also be sensitive to laser light as is the imaging layer. Generally, this enhances imaging and/or developing speeds. In embodiments, the overcoat layer can be that described in US patent publication US 2010/0215944.

In embodiments, the image forming layer is coated with another image forming layer as known in the art. This second layer may increase the imaging speed and provide longer run length.

Depending on the image forming layer used, the lithographic printing plate of the disclosure may be imaged with near infrared laser radiation having a wavelength between 780 and 1,100 nm or ultraviolet laser radiation having a wavelength between 350 and 450 nm.

### The Base Layer

Together the base layer and the aluminum layer form the substrate of the printing plate. Taken together, they provide enough structural strength for the printing plate to be easily handled and used on printing presses. The printing plate should be flexible, thick and strong enough to be manipulated and used on typical lithographic printing presses and other associated machines, such as plate-setters, and to maintain its structural integrity and shape. It should also be flexible enough to be readily installed on printing press cylinders (that have a curved surface necessitating the printing plate to bend to adopt the same curve).

The exact nature of the base layer material is not crucial. The material can be chosen based on cost and handling characteristics. It is sufficient that the base layer, together with the other layers, of the printing plate, the base layer provides the desired structural strength.

In embodiments, the base layer is between about 10 and about 350 µm thick, preferably between about 10 to about 300 µm, more preferably between about 50 to about 300 µm, most preferably between 100-200 µm, such as between 100-150 µm.

In embodiments, the base layer can be a plastic layer, a composite layer, a cellulose-based layer such as cardstock or paper, or a non-woven fabric layer.

In embodiments, when the base layer is a plastic layer, it can be a solid plastic layer, a multi-laminate layer, or a plastic foam layer. Of course, such foam would be sufficiently dense so as to contribute to the structural strength of the substrate.

In embodiments, the base layer comprises a thermoplastic resin, such as a petroleum based thermoplastic resin or a biomass based thermoplastic resin. Example of such resins include polystyrene (PS), polyolefins such as polyethylene (PE) and polypropylene (PP) (including oriented PP, such biaxially oriented PP (or BOPP)), polyesters, such as polyethylene terephthlate (PET), polyamide (PA), polyvinyl chloride (PVC), polyetheretherketone (PEEK), polyimide (PI), polyvinylacetate (PVA), polyalkylacrylate (PAAA), polyalkylmethacrylate (PAMA), polylactide, polybutahydroburate, polysuccinamate, cellulosic polymers, copolymers thereof, and mixtures thereof. In embodiment, the base layer is made of a PET film (for example with a thickness of 120 or 130 µm), a BOPP film (for example with a thickness of 120 µm), or a PP film (for example a thickness of 120 µm).

These thermoplastic resins, and any plastic used as a base layer, may comprise one or more fillers. These fillers may play different roles as needed: they can make the base layer harder, they can make the base layer rougher and/or they can lower the density of the base layer. Making the base layer harder contributes to the structural strength of the substrate. Making the base layer rougher reduces the stickiness of printing plates with each other, which allows staking them for storage or use without using interleaving paper. This also eliminates the need for interleaving paper when cutting the printing plates to size. Making the base layer less dense lowers the weight of the substrate and eases its recycling as explained below. In embodiments, the amount of fillers in the resins is between about 5 to about 85 % by weight, for example between about 10 and about 30/%, and more specifically about 20%. The filler may be an inorganic filler, such as, for example, calcium carbonate, silica, alumina, titanium oxide, aluminosilicate, zeolite and fiberglass. The filler may also be an organic carbohydrate flour, such as that obtained from biomass and natural fibers, such as starch, sawdust, rice husks, rice straw, wheat straw, and sugarcane bagasse. The filler may also be carbon black or another similar material.

In embodiment, the base layer is a PP film (for example a thickness of 120 µm) comprising 20 % of calcium carbonate.

In embodiments, the base layer may further comprise pigments or colorants. These allow, for example, identifying a given product or a given brand. The base layer may also comprise polymer processing additives, such as antioxidants and flowing agents for example.

In embodiments, the base layer is paper coated with a polymer layer on at least one side (it is not necessary to coat the paper on the side facing the adhesive layer). The polymer layer can be a polybutyrate or polyacetal layer.

In the interest of making the substrate recyclable, in embodiments, the base layer is made of a recyclable material. In specific embodiments, the base layer has a density lower than the density of a processing liquid, which is typically water or a water-based solution (such as an alcohol-water mixture) as described below, the processing liquid itself having a density lower than the density of the aluminum layer, which is also recyclable. This helps separating the different substrate layers during recycling (see below). In that regard, polyethylene and polypropylene are particularly advantageous as they have densities lower than 1 (1 being the density of water).

### The Adhesive Layer

The adhesive layer provides for the adhesion of the base layer to the aluminum layer base layer during use of the printing plate (including development and printing).

As stated above, the adhesive layer is accessible to the inks, fountains solutions and developers used in printing and developing the printing plate as disclosed herein. This means that the inks, fountains solutions and developers can contact the adhesive along the whole periphery of the printing plate. During development and use in printing, the inks, fountains solutions and developers will come into contact with the adhesive layer at the edges of the printing plate. Compared to the substrate disclosed in US patent publication no. 2011/0277653, there is no sealed (or otherwise protected) edges shielding the adhesive from the inks, fountains solutions and developers. As stated in US patent publication no. 2011/0277653 however, two edges of the printing plate may be protected from contact with liquids during printing (but not during off-press development) by the clamps used to hold the printing plates on the printing plates.

The above absence of seal eases the manufacture of the printing plates as disclosed in the present document. However, to prevent delamination at unwanted times, the adhesive layer in the printing plates is not soluble in the developers, fountain solutions and developers. The adhesive layer should indeed be insoluble or show little solubility in these liquids otherwise the printing plate would risk delamination during development and/or printing. Therefore, if the printing plate is for use with alkaline developers and/or alkaline fountain solutions, the adhesive should be insoluble in alkaline aqueous solutions, and if the printing plate is for use with acidic developers and/or acidic fountain solutions, the adhesive layer should be insoluble in acidic aqueous solutions. Also, the adhesive should not be soluble in the inks used for printing (these inks are oleophilic as explained above).

As taught below, when manufacturing the printing plates as disclosed, the aluminum oxide layer and image forming layer (and other optional layers) are manufactured before the adhesive layer is applied and the base layer is laminated on the aluminum layer. This method of manufacture represents an advance, since it integrates more easily into existing printing plate produce lines. It also relaxes the requirements regarding the adhesive layer as there is no need for it to resist any of the liquids used during the manufacture of the aluminum oxide layer and image forming layer (and other optional layers).

The adhesive layer can be of various natures. It can be a layer of a drying adhesive, i.e. an adhesive that hardens by drying. It can also be a layer of a hot-melt adhesive, i.e. an adhesive that hardens by cooling. Finally, the adhesive layer can be dry adhesive compliant layer that adhere to the second aluminum oxide layer as discussed below.

**Drying Adhesives.** The drying adhesives that can be used in the adhesive layer are solvent based adhesives, which typically comprise one or more ingredients (typically polymers) dissolved in a solvent. As the solvent evaporates, the adhesive hardens. Thus, the drying adhesives for use in the adhesive layer should be soluble in such solvent (water based or not) so they can be applied to the base layer.

Further, as discussed above, once dried, these adhesives should not be soluble in the oleophilic inks used with the printing plate. This can be achieve by selecting adhesive that are soluble in aqueous solutions rather than in oleophilic solvents.

In addition, however, these adhesives should not be soluble in the aqueous developers, and fountain solutions that will be used with the printing plate, while being soluble in the aqueous processing liquid to be used for delamination (see below for more details on recycling). The present inventors have achieved this by selecting the nature of the processing liquid in function of the nature of the developers and/or fountain solutions used during use of the printing plate. If the developers and/or fountain solutions are acidic, then the processing liquid will be alkaline. If the developers and/or fountain solutions are alkaline, then the processing liquid will be acidic. In other words, the drying adhesive must be either (A) soluble in alkaline aqueous solution, but insoluble in acidic aqueous solutions, or (B) soluble in acidic aqueous solution, but insoluble in alkaline aqueous solutions.

All of the above can be achieved by polymers that have a relatively low Tg (glass transition temperature), for example between about 10 and about 60°C, preferably between about 15 and about 20°C, so they are tacky. Such polymers should comprise sufficient polar functional groups (alcohols, carboxyls, amides, and the like) that provide solubility in aqueous solutions and limit solubility in oleophilic media. Such polymers include acrylate, urethane, urea, epoxy, or ester polymers. Preferred polymers are acrylate polymers as they are economical and are easy to modify.

Further, these polymers should comprise either sufficient acidic functional groups (such as -COOH) that provide solubility in alkaline aqueous solutions or sufficient basic functional groups (such as amines) that provide solubility in acidic aqueous solutions depending on its desired solubility characteristics.

An example of a polymer that is soluble at an acidic pH, but insoluble at alkaline pH, is a copolymer of alkyl acrylate monomers with dialkylamino alkyl acrylate monomers. The presence of dialkylamino alkyl acrylate monomers, which contain a basic amino group, provides solubility in acidic aqueous solutions. The solubility of the copolymer can thus be fine-tuned by adjusting the ratio of this monomer compared to the other monomers. Examples of dialkylamino alkyl acrylate monomers include dimethylamino-ethyl-acrylate, diethylamino-ethyl-acrylate, and dibutylamino-ethyl-acrylate. Examples of alkyl acrylate monomers include ethyl acrylate and methyl acrylate. A specific example of such a copolymer is a copolymer of methyl acrylate (5-15% by weight), ethyl acrylate (50-80% by weight), and dimethylamino ethyl acrylate (5-20% by weight). The percentages value being based on the total weight of the copolymer. Such a polymer is, for example, sold under the tradename Elastak™ 1020.

An example of an adhesive that is soluble at an alkaline pH, but insoluble at acidic pH, is a copolymer of alkyl acrylate monomers with acrylic acid monomers. The presence of acrylic acid monomers, which contain acidic groups, provides solubility in alkaline aqueous solutions. The solubility of the copolymer can thus be fine-tuned by adjusting the ratio of this monomer compared to the other monomer. Examples of alkyl acrylate monomers include the same as above. A specific example of such a copolymer is a copolymer of methyl acrylate (5-15% by weight), ethyl acrylate (50-80% by weight), and acrylic acid (5-20% by weight). The percentages value being based on the total weight of the copolymer. Such a polymer is, for example, sold under the tradename Elastak™ 1000.

In both cases above, the Tg of the copolymers is controlled by the ratio of various monomers. For example, pure poly(methylacrylate) has a Tg of about 10°C, pure poly(ethylacrylate) has a Tg of about -21°C, pure poly (dimethylamino ethyl acrylate) has a Tg of about 19°C, while pure poly(acrylic acid) has a Tg of about 105 °C.

**Hot-melt Adhesives.** The hot-melt adhesives that can be used in the adhesive layer are thermoplastics applied in molten form that solidify on cooling to form adhesive bonds between the aluminum layer and the base layer.

Again, once cooled, these adhesives should not be soluble in the oleophilic inks used with the printing plate.

In addition, the hot-melt adhesives should not be soluble in the developers and fountain solutions that will be used with the printing plate.

It should be noted, that contrary to the above, it is not necessary that the hot-melt adhesive be soluble in a processing liquid as they can very simply be melted, which allows delaminating without using any processing liquid. This relaxes the solubility requirements on the hot-melt adhesive (compared to the drying adhesive) as they simply need to be relatively insoluble in all liquids involved, rather than having additionally to be selectively soluble in a processing liquid.

Examples of suitable hot-melt adhesives include ethylene-vinylacetate polymer, polyamide, polyolefin, reactive polyurethane, and ethylene-acrylic ester-maleic anhydride terpolymers. In particular, the adhesives sold under the tradenames:
- Lotader™ (including product 3210, a random terpolymer of ethylene, acrylic ester and maleic anhydride) from Arkema, USA),
- Dorus™ (including product KS 351, an ethylene-vinylacetate polymer from Henkel, USA), Macromelt® (including product TPX 16-344 UBK™, a polyamide) from Henkel, USA, and
- Affinity™ (including product GA1875, a polyolefin elastomer) from Dow, USA are noted.

A sub-class of hot-melt adhesive are reactive hot-melt adhesives, which after solidifying, undergo further curing e.g., by moisture, by ultraviolet radiation, electron irradiation, or by other methods.

Examples of such adhesives include the reactive urethane adhesives sold under tradenames:
- Suprasec® from Huntsman, USA,
- Purmelt® (including product QR-6205) from Henkel, USA,
- Terorehm® (including product MC9520 and MC9530, moisture curing polyurethanes from Henkel, USA, and
- Mor-Melt™ (including product R5003, a moisture curing polyurethane) from Dow, USA.

It will be apparent to the skilled person that the melting point of the hot-melt adhesive should be below that of the base layer.

In embodiments of all of the above types of adhesives, the adhesive layer is between about 10 and about 300 µm thick, preferably between about 10 and about 100µm , most preferably between about 10 and 50 µm. In embodiments, the adhesive layer is about 20 µm thick.

### Dry adhesives.

When a dry adhesive is used, the backside of the aluminum layer (i.e. the side opposite the image forming layer) must be covered by a "second" aluminum oxide layer. Such aluminum oxide layer, prepared by graining and anodization as described below, comprises nano- and micro-pores that are involved in the dry adhesion.

The base layer is covered by the adhesive layer which, in this case is a dry adhesive compliant layer.

As demonstrated in International Patent Publication no. WO 2012/155259, such a dry adhesive compliant layer will reversibly adhere to the aluminum oxide layer. More specifically, it is believed that the dry adhesive compliant layer adheres to the micro- and nano-pores of the aluminum oxide layer because of physical (e.g. van der Waals) and/or chemical interactions between the micro- and nano-pores and the dry adhesive compliant layer, which, being compliant, conforms with the topography of the featured surface to form reversible mechanical interlock. Thus, when the dry adhesive compliant layer is brought into physical contact with the aluminum oxide layer that bears both micro- and nano-pores, an adhesive bond instantaneously forms between them. This bond is reversible and the surfaces may be detached from one another.

As such, the compliant material in the dry adhesive compliant layer can be any of those described in International Patent Publication no. WO 2012/155259 (see the section entitled "Compliant Surface) as long as the dry adhesive compliant layer is not soluble in the oleophilic inks, developers and fountain solutions that will be used with the printing plate. It should be noted however that it is not necessary that the dry adhesive compliant layer be soluble in a processing liquid as the dry adhesion means that the base layer bearing the dry adhesive compliant layer can very simply be peeled off the second alumiunum oxide layer, which allows delaminating without using any processing liquid.

The dry adhesive compliant layer has a relatively low modulus so that it is able to deform and conform to the pores in the "second" aluminum oxide layer. In embodiments, the compliant material or surface has a hardness of 60 Shore-A or less, preferably 55, 50, 45, 40, 35, 30, or 25 Shore-A or less. In these or other embodiments, the compliant material or surface has a hardness of 20, 25, 30, 35, 40, 45, 50, or 55 Shore-A or more

In embodiments, the compliant surface is made of a polymer, non-limiting examples of which include thermoplastic polymers, thermoplastic elastomers, and crosslinked elastomers.

Suitable polymers include, but are not limited to, natural polyisoprene, synthethic polyisoprene, polybutadiene, polychloroprene, butyl rubber, styrene-butadiene rubber, nitrile rubber, ethylene propylene rubber, epichlorohydrin rubber, polyacrylic rubber, silicone rubber, fluorosilicone rubber, fluoroelastomers, perfluoroelastomers, polyether block amides, chlorosulfonated polyethylene, ethylene-butadiene copolymer elastomers, ethylene-vinyl acetate, silicone elastomer, polyurethane elastomer, aminopropyl terminated siloxane dimethyl polymers, styrene-ethylene/propylene-styrene (SEPS) thermoplastic elastomer, styrene-ethylene/butylene-styrene (SEBS) thermoplastic elastomer, styrene-isoprene-styrene (SIS) thermoplastic elastomer, styrene-butadiene-styrene (SBS) thermoplastic elastomer, and/or styrene-ethylene/butylene-styrene grafted with maleic anhydride thermoplastic elastomer.

In embodiments, the compliant material making the dry adhesive compliant layer is an elastomer having a hardness between 40 and 55 Shore D.

The table below shows non-limiting examples of thermoplastic elastomers together with some of their physical properties. The thermoplastic elastomers are listed with their hardness (Shore A), elongation at break (%), and/or tensile strength (psi, mPa). Kraton thermoplastic elastomers are available through Kraton Polymers in Houston, TX. The datasheets of these polymers are available to the skilled person through the website www.kraton.com.

| **Name** | **Hardness (Shore A)** | **Elongation at break (%)** | **Tensile strength** |
|---|---|---|---|
| **KRATON® D SIS** - Styrenic block copolymers based on styrene and isoprene | | | |
| KRATON® D1114 P Polymer (Clear, linear triblock copolymer based on styrene and isoprene with a polystyrene content of 19%.) | 42 | 1300 | 32,72 mPa (4600 psi) |
| KRATON® D1160 B Polymer (Clear linear triblock copolymer based on styrene and isoprene with bound styrene of 18.5% mass.) | 48 | 1300 | 31.99 mPa (4640 psi) |
| KRATON® D1161 B Polymer (Clear, linear block copolymer based on styrene and isoprene with a polystyrene content of 15%.) | 30 | 1300 | 27.99 mPa (4060 psi) |
| KRATON® D1163 P Polymer (Clear, linear triblock copolymer based on styrene and isoprene, with a polystyrene content of 15%) | 25 | 1400 | 10.34 mPa (1500 psi) |

| **KRATON® D SBS** - Block copolymers composed of blocks of styrene and butadiene | | | |
|---|---|---|---|
| KRATON® D4141 K Polymer (31% styrene) | 50 | 1300 | 18.96 mPa (2750 psi) |
| KRATON® D4150 K Polymer (Linear triblock copolymer based on styrene and butadiene with a polystyrene content of 31%.) | 45 | 1400 | 19.30 mPa (2800 psi) |
| KRATON® D4158 K Polymer (Oiled, radial copolymer based on styrene and butadiene with a polystyrene content of 31%.) | 41 | 1110 | 9.17 mPa (1330 psi) |

| **KRATON® G SEBS/SEPS** - Styrenic block copolymers with a hydrogenated midblock of styrene-ethylene/butylene-styrene (SEBS) or styrene-ethylene/propylene-styrene (SEPS) | | | |
|---|---|---|---|
| KRATON® G1645 M Polymer (Linear triblock copolymer based on styrene and ethylene/butylene) | 35 | 600 | 10.34 mPa (1500 psi) |
| KRATON® G1657 M Polymer (Clear, linear triblock copolymer based on styrene and ethylene/butylene with a polystyrene content of 13%) | 47 | 750 | 23.44 mPa (3400 psi) |
| KRATON® G1702 H Polymer (Clear, linear diblock copolymer based on styrene and ethylene/propylene with a polystyrene content of 28%. | 41 | <100 | 2.07 mPa (300 psi) |
| KRATON® G4609 H Polymer (White mineral oil extended linear triblock copolymer based on styrene and ethylene/butylene with a polystyrene content of 33%. Nominal oil content of the polymer is 45.5%w (90 parts/100 parts rubber (phr)). | 22 | - | 5.52 mPa (800 psi) |

| **KRATON® FG** - SEBS polymers with 1.0 to 1.7 wt. % maleic anhydride (MA) grafted onto the rubber midblock | | | |
|---|---|---|---|
| KRATON® FG1924 G Polymer (Clear, linear triblock copolymer based on styrene and ethylene/butylene with a polystyrene content of 13%.) | 49 | 750 | 23.44 mPa (3400 psi) |

The table below shows non-limiting examples of crosslinked elastomers together with some of their physical properties. The crosslinked elastomers are listed with their hardness (Shore A), elongation at break (%), tensile strength (mPa, psi), and tear strength (kN/m). The silicone elastomers are available through Dow Corning. The datasheets of these polymers are available to the skilled person through the website www.dowcorning.com.

| **Name** | **Durometer (Shore A)** | **Elongation (%)** | **Tensile Strength** | **Tear Strength (kN/m)** |
|---|---|---|---|---|
| Dow Corning® 3631 (Two-part, solvent free, heat-cured liquid silicone rubber.) | 19 | 800 | 5.00 mPa (725 psi) | 16 |
| Dow Corning® D94-20P (Two-part, 1:1 ratio, addition cure silicone elastomer) | 21 | 900 | 5.27 mPa (765 psi) | N/A |
| Dow Corning® D94-30P (Two-part, 1:1 ratio, addition cure silicone elastomer) | 33 | 800 | 6.89 mPa (1000 psi) | 16.1 |
| Silastic ® LC-20-2004 (20 Durometer, 2 parts, 1 to 1 mix, translucent, FDA 21 CFR 177.2600 and BfR, XV, molding and injection molding grade Liquid Silicone Rubber) | 20 | 900 | 6.48 mPa (940 psi) | 24 |
| Silastic ® LC-9426 (Two-part liquid silicone rubber) | 20 | 790 | 4.20 mPa (609 psi) | 23 |
| Silastic® 94-595 (40 Durometer, 2-part, 1 to 1 mix, translucent Liquid Silicone Rubber) | 42 | 610 | 10.00 mPa (1450 psi) | 34 |
| Silastic® 94-599 (47 Durometer, 2-part, 1 to 1 mix, translucent, molding grade, Liquid Silicone Rubber) | 49 | 590 | 11.00 mPa (1595 psi) | 32 |
| Silastic® LC-9434 (two-part liquid silicone rubber) | 33 | 790 | 5.49 mPa (797 psi) | 32 |
| Silastic® LC-9436 (two-part liquid silicone rubber) | 29 | 720 | 5.90 mPa (855 psi) | 28 |
| Silastic® LC-9451 (two-part liquid silicone rubber) | 50 | 540 | 7.60 mPa (1102 psi) | 30 |
| Silastic® LC-9452 (two-part liquid silicone rubber) | 50 | 560 | 7.00 mPa (1015 psi) | 34 |
| Silastic® LC-9454 (two-part liquid silicone rubber) | 50 | 530 | 7.20 mPa (1044 psi) | 29 |
| DOW CORNING Class VI Elastomers C6-530 (heat cured elastomer raw materials) | 30 | 831 | 8.20 mPa (1189 psi) | 27.5 |
| DOW CORNING Class VI Elastomers C6-540 (heat cured elastomer raw materials) | 40 | 742 | 8.91 mPa (1293 psi) | 41.9 |
| Dow Corning® S40 (Two-part platinum-catalyzed silicone elastomer) | 40 | 864 | 8.62 mPa (1250 psi) | 31.2 |
| Dow Corning® S50 (Two-part platinumcatalyzed silicone elastomers) | 48 | 610 | 8.79 mPa (1275 psi) | 42.5 |
| Dow Corning® D94-45M (Two-part, 1:1 ratio, addition cure silicone elastomer) | 45 | 600 | 7.24 mPa (1050 psi) | 45 |

Another example of compliant material is QLE1031; a heat curable silicone elastomer available from Quantum Silicones, Virginia, USA. The datasheet of this polymer is available to the skilled person through the website www.quantumsilicones.com.

In embodiments, the dry adhesive compliant layer is between about 5 and about 80 µm thick, preferably between about 10 and 50 µm.

### Figures 1-3

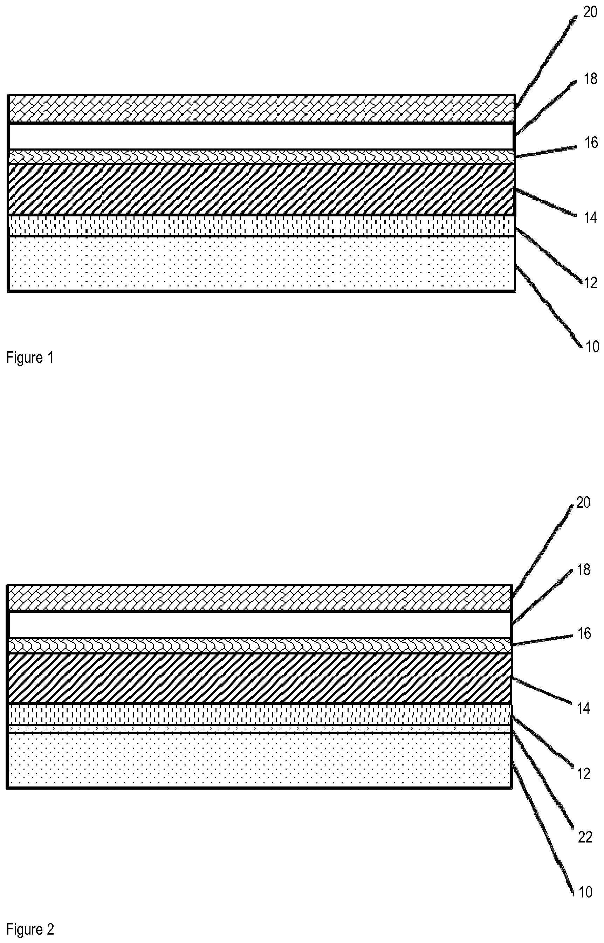

A crude scheme of an embodiment of the printing plate can be seen in Figure 1. The substrate in this figure comprises base layer (10), adhesive layer (12) on the base layer (10), and aluminum layer (14) laminated on the base layer (10) through the adhesive layer (12). Then, the aluminum layer (14) bears the first aluminum oxide layer (16), which bears the image forming layer (18). In the particular embodiments illustrated, the image forming layer (18) bears optional layer (20), which can be, for example, a second image forming layer or an overcoat layer.

In embodiments, the printing plate further comprises a silicone release layer between the base layer and the adhesive layer. Such an embodiment is shown in Figure 2 where the silicone release layer (22) is shown between base layer (10) and adhesive layer (12). This silicon release layer is usually coated on biaxially oriented polyterephthalate films. It can also be coextruded on polyterephthalate or polypropylene films.

The base layer having a silicone release layer is particularly useful when using hot-melt adhesives that are to be processed (in view of recycling) by melting rather than dissolution. In those cases, the release layer eases the delamination of the printing plate. The preferable silicone release layer coextruded on polyterephthalate and polypropylene films are available from Mylan Optoelectronics under the Elastack® R-PET and Elastack® R-PP tradenames.

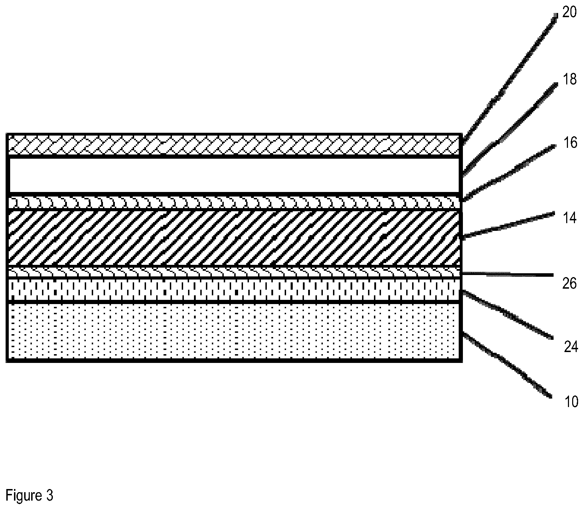

Figure 3 shows a printing plate where a dry adhesive is used. In such embodiments, aluminum layer (14) bears a second aluminum oxide layer (26), which allows for the dry adhesion of the adhesive layer, which in this case is a dry adhesive compliant layer (24).

### Advantages

The above printing plates have, in embodiments, several advantages.

A first of these advantages is the reduced thickness of the aluminum layer. This reduces the cost of production compared to using plain aluminum substrates (aluminum being expensive). This also reduces the weight of the printing plates (the base layer being usually less dense than aluminum), which in turn reduces the shipping weight and costs. This also reduces the recycling cost as aluminum recycling is energy-consuming and thus expensive.

Another advantage is the elimination of the need for interleaving paper (especially with certain base layers). This also reduces the shipping volume and costs. This also reduces handling costs.

As explained below, in more details, the manufacture of these printing plates, and their delamination in view of recycling is eased.

Another advantage is typically long runs on press as illustrated by the examples below.

### Manufacture of the Printing Plates

In another aspect, the present document provides methods of manufacturing a lithographic printing plate substrate. In this aspect, the base layer, the various adhesive layers, the aluminum layer, the aluminum oxide layers, and all other layers are as defined above.

As stated above, the base layer is laminated on the aluminum layer through an adhesive layer. More specifically, it is located on the side opposite the image layer.

Since, the edges of the base layer and the aluminum layer are not sealed together; the adhesive layer is accessible along the periphery of the printing plate. "Accessible" means that the various liquids used in making, developing and using the printing plates can be in direct contact with the adhesive. These liquids are quite diverse. It was thus a challenge to produce a printing plate that can resist all these aggressions without delaminating and then readily delaminates in view of recycling.

The method of manufacture of the printing plate partly overcomes this problem by laminating the base layer on the aluminum layer after all the printing plate manufacturing steps involving liquids have been completed. In embodiments, the lamination takes places after all the printing plates manufacturing steps have been carried out, but for said lamination (and, in embodiments, cutting the printing plate to the desired size). This lessens the demands on the adhesive as it then only needs to resist the liquids used in development and printing.

This, in fact, constitutes an advantage of the present disclosure as it means that the lamination can easily be incorporated into any already existing process for manufacturing a printing plate. In the simplest cases, the production of printing plates simply involves adding a lamination step at the end of an already existing printing plate manufacturing process (or towards the end of such a process, for example just before cutting to size).

The manufacturing of the printing plate, thus comprises the step of providing a lithographic printing plate as is known in the prior art (such plate comprising at least an aluminum layer bearing an image layer), providing an adhesive layer and a base layer, and then laminating the base layer on the aluminum layer on the side opposite the image layer, the laminating being carried out through the adhesive layer. In such a process, the thickness of the aluminum layer of the printing plate would typically be reduced compared to prior art process as the base layer provides structural integrity to the printing plate produced. This constitutes another advantage as less aluminum (which is costly) is used in the making of the printing plate.

In embodiments, the step of providing a lithographic printing plate as is known in the prior art comprises providing an aluminum layer with an aluminum oxide layer and producing an image layer on the aluminum oxide layer.

In embodiments, the step of providing an aluminum layer with an aluminum oxide layer comprises providing an aluminum layer and producing an aluminum oxide on at least one side of the aluminum layer. This layer can be produced by directly subjecting the aluminum layer to an electrolytic process. This electrolytic process can be carried out on a continuous production line with a web process or sheet-fed process.

The step of providing an adhesive layer will vary depending of the type of adhesive used. Adhesives can be coated on the base layer in liquid form and allowed to cure or dry as needed. Hot-melt adhesive can be melted and similarly coated on the base layer. Hot-melt adhesives can also be applied, for example by extrusion, at a temperature at which they are melted, just before lamination. Dry adhesive can also be prepared as described below.

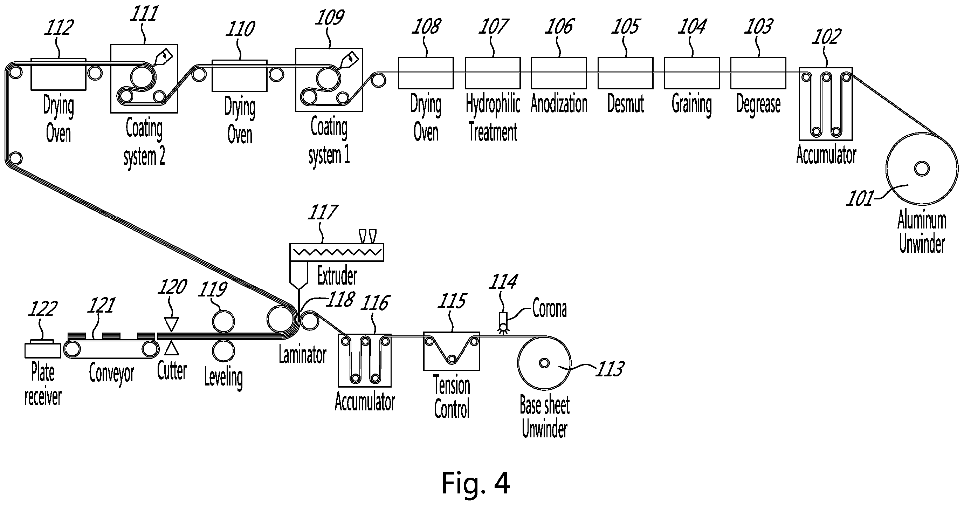

A description of a specific embodiment of the above methods now follows with reference to Figures 4 to 6.

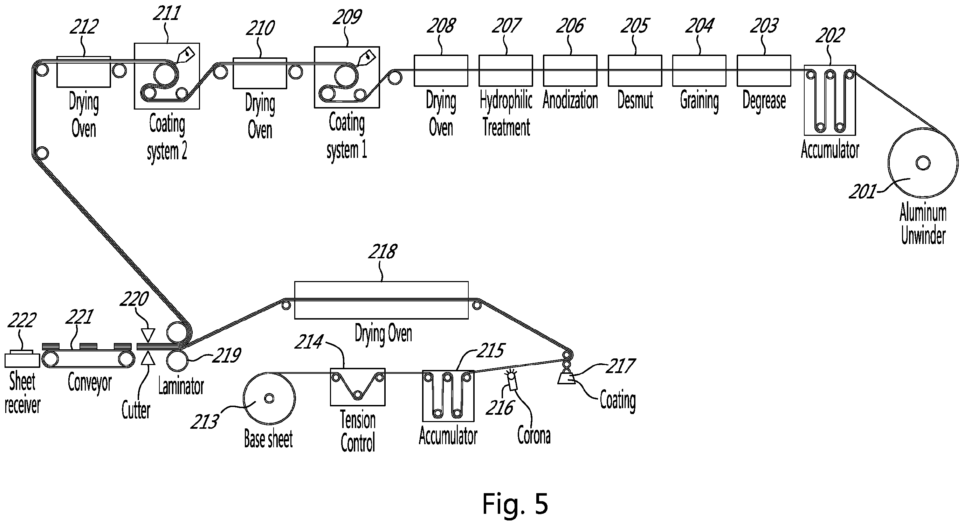

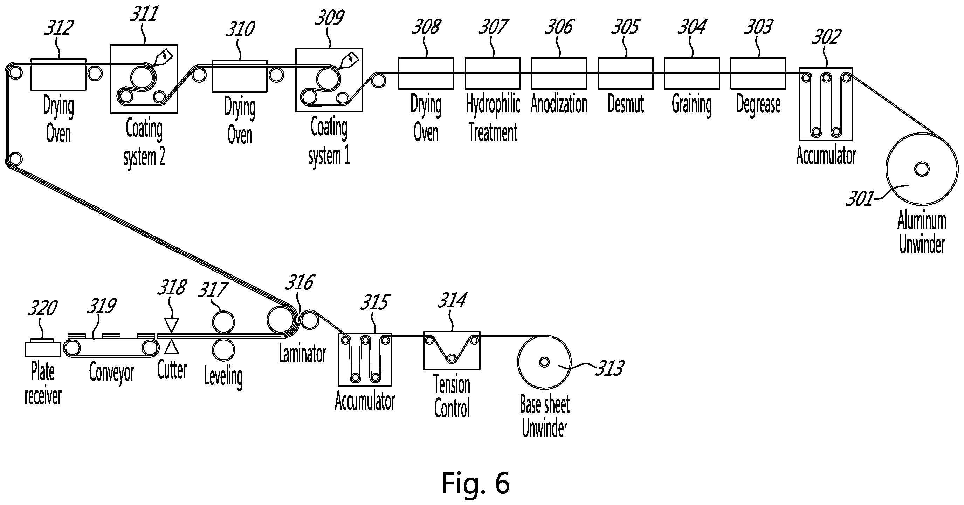

Figure 4 shows a process for making a printing plate wherein the adhesive is a hot-melt adhesive that is extruded just before lamination of the base layer on the aluminum layer. Figure 5 shows a similar process in which, before lamination, an adhesive is coated on the base layer and dried, thereby forming an adhesive layer. Figure 6 shows a process for making a printing plate in which a dry adhesive is used.

### Extruded Adhesives

In Figure 4, an aluminum layer is unwound from a coil (101) and goes through an accumulator (102).

The accumulator is optional; it is useful when switching rolls of the starting materials (at 101), when a roll runs out.

The aluminum layer is then subjected to an electrolytic process (203-208) aiming to form the aluminum oxide layer. This electrolytic process can be carried out on a continuous production line with a web process or sheet-fed process. Figure 4 shows a continuous process.

The aluminum layer is thus degreased (103). In embodiments, this step comprises washing the aluminum layer with, for example, an aqueous alkaline solution containing sodium hydroxide (3.85 g/l) and sodium gluconate (0.95 g/l) at 65°C to remove any organic oil and crease from its surface; neutralizing with, for example, aqueous hydrochloric acid (2.0 g/l); and finally washing with water to remove the excess of hydrochloric acid solution.

The clean aluminum layer then undergoes electrolytic graining (104), for example in an aqueous electrolyte containing an aqueous solution of hydrochloric acid (8.0 g/l) and acetic acid (16 g/l), using carbon electrodes at 25°C. The current and charge density may be 38.0 A/dm² and 70.0 C/dm², respectively;

After graining, the aluminum undergoes desmuting (105), which removes unwanted impurities before anodization. This can be accomplished, for example, with an aqueous sodium hydroxide solution (2.5 g/l), followed by neutralizing with an aqueous sulfuric acid solution (2 g/l); and washing with water to remove the excess acid.

The aluminum layer then undergoes anodizing (106) thus producing the aluminum oxide layer. Anodization can take place, for example, in an aqueous electrolyte containing sulfuric acid (140 g/l) at 25°C; the current and charge density being adjusted to produce an aluminum oxide layer having a thickness between about 2.5 and about 3.0 g/m².

The aluminum oxide layer is then washed with water and treated to enhance the hydrophilicity of its surface. This can be achieved, for example with an aqueous solution containing sodium dihydrophosphate (50 g/l) and sodium fluoride (0.8 g/l) at 75°C followed by washing with water at 50°C.

The aluminum/aluminum oxide layers are then dried (108), for example with hot air at 110°C in an oven.

Then, aluminum/aluminum oxide layers may be rewound into coils. Alternatively, as shown in Figure 4, they are directly coated with an image forming layer. Figure 4 indeed shows that the image forming layer is then coated on the aluminum oxide layer (109) and dried (110), for example at a temperature between 100 and 150°C using hot air or near infrared heating tubes.

Optionally, an overcoat layer or a second image forming layer is then coated on the first image forming layer (111) and dried in the same way (112).

The lithographic printing plate thus produced is ready to be laminated with the base layer.

The preparation of the base layer for lamination (113-116) can take place before, after, or during the electrolytic treatment of the aluminum layer (steps 101-108) and/or the coating/drying steps (109-112).

The preparation of the base layer for lamination as shown in Figure 4 includes unwounding the base layer (113). In embodiments, this base layer already bears the optional silicone release layer. The base layer is the corona treated (114) as needed. Corona treatment will enhance the surface polarity and thus the adhesion the polymeric materials. The base layer then goes through an optional tension controller (115) and an optional accumulator (116). It should indeed be noted that the tension controller and accumulator are less useful when an automatic base layer coil exchanger is used.

Figure 4 shows a preferred sequence for steps 114, 115, and 116. However, it will be apparent to the skilled person that it can vary.

A hot-melt adhesive in then extruded (117) on the base layer or on the aluminum layer (on the side opposite the image forming layer). This extrusion forms the adhesive layer. Preferably, the hot-melt adhesive in extruded on the base layer. The extrusion can be carried out using, for example, a single-screw extruded.

The aluminum layer and the base layer bearing the adhesive are then laminated (118). During lamination the adhesive layer faces the side of the aluminum layer that does not bear the image forming layer. Lamination is effected by passing the two webs between two rollers as shown in Figure 4.

The laminated product then passes though further rolls (119) for chilling (at for example 45°C) and if needed leveling.

After lamination, the printing plates are cut to size (120) as needed, and handled as is desired (for example being transported by a conveyor (121) to a sheet receiver (122) to be boxed or used.

If a silicon release layer is present on the base layer, it can prepared on the base layer offline. The base layer with the silicon release layer on it is then rewinded, and loaded on the production line (113). In alternative embodiments, not shown, the silicon release layer can be prepared online, this being done prior to corona treatment 114.

The silicon release layer can be prepared by coating a solvent based solution on the base layer followed by drying at an appropriate temperature, for example between about 100 and about 150°C. Alternatively, the silicon release layer can be prepared by coating a solvent-less liquid on the base layer followed by curing at an appropriate temperature, for example between about 100 and about 150°C.

### Coated Adhesives

In the alternative process shown in Figure 5 (coated adhesive), steps 201-212 and 220-222 are identical to steps 101-112 and 120-122 of Figure 4, respectively. Again, the preparation of the base layer (213-218) for lamination can take place before, after, or during the electrolytic treatment of the aluminum layer (steps 201-208) and/or the coating/drying steps (209-212).

The base layer is unwound (213). The base layer then goes through an optional tension controller (214) and an optional accumulator (215). It is then corona treated (216) as needed. Again, Figure 5 shows a preferred sequence for steps 214, 215, and 216. However, it will be apparent to the skilled person that it can vary.

The base layer is then coated (217) with an adhesive in liquid form to form the adhesive layer. The adhesive layer can have, for example, a thickness between about 1 and about 20 µm. The adhesive that is coated can be in the form or an adhesive solution, which can be water based or solvent based. The adhesive that is coated can also be in liquid form, but solvent-less, for example it can be a melted hot-melt adhesive.

If an adhesive solution was used, the coating is followed by drying (218) using hot air or infrared heating tubes at a temperature between 100 and 150°C.

In the case of a solvent-less adhesive that needs curing, the drying (218) is replaced by curing, for example at a temperature of about 120°C, as needed. If the solvent-less adhesive is a hot-melt adhesive, drying (218) is simply ignored. Lamination should however take place before the adhesive cools.

The aluminum layer and the base layer are then laminated (219). During lamination the adhesive layer is between the side of the aluminum layer that does not bear the image forming layer and base layer. Lamination is effected by passing the two webs between two rollers as shown in Figure 5.

After lamination, the printing plates are then cut to size (220) as needed, and handled as desired (for example being transported by a conveyor (221) to a sheet receiver (222) to be boxed or used.

### Dry Adhesives

In the alternative process shown in Figure 6 (dry adhesives), steps 301-312 and 318-320 are identical to steps 101-112 and 120-122 of Figure 4, respectively, except for the fact that both sides of the aluminum layer are treated in steps 303-308 and therefore an aluminum oxide layer is formed on each side of the aluminum layer.

Again, the preparation of the base layer (313-315) for lamination can take place before, after, or during the electrolytic treatment of the aluminum layer (steps 301-308) and/or the coating/drying steps (309-312).

The preparation of the base layer for lamination as shown in Figure 6 includes unwounding the base layer (313). The base layer then goes through an optional tension controller (314) and an optional accumulator (314).

In such embodiments, the base layer already bears a dry adhesive compliant layer that has been prepared on the base layer offline. The base layer with the compliant dry adhesive layer on it is then rewinded, and loaded on the production line (313). In alternative embodiments, not shown, the compliant dry adhesive layer can be prepared online, this being done at any point between step 313 and step 316.

In any cases, the compliant dry adhesive layer can be prepared by hot-melt extrusion or by solvent coating on the base layer. As needed, an adhesive or tie layer can be used to have the dry adhesive compliant layer adhere on the base layer (it should be remembered that the dry adhesive compliant layer will typically not adhere on surfaces that do not bear nano- and micro-pores).

The aluminum layer and the base layer are then laminated (316). During lamination the compliant dry adhesive layer is between the electro-grained and anodized aluminum oxide layer (comprising nano- and micro-features) on the backside of the aluminum substrate (i.e. on the side that does not bear the image forming layer) and base layer. Lamination is effected by passing the two webs between two rollers as shown in Figure 6. This will allow dry adhesion through mechanical interlock of the compliant layer within the nano- and micro-pores of the aluminum oxide layer.

The laminated product then passes though further rolls (317) for leveling. After lamination, the printing plates are then cut to size (318) as needed, and handled as desired (for example being transported by a conveyor (319) to a sheet receiver (320) to be boxed or used.

### Delamination of the Printing Plates in View of their Recycling

In use, the printing plates will not be delaminated by the liquids used during development and printing. This is because the adhesive layer is insoluble in the developers, fountain solutions, and inks involved during use of the printing plate. This is achieved in various ways as described above.

In an aspect of the disclosure, there is provided a method of delaminating the above lithographic printing plate (typically after use) in view of recycling.

This method allows separating the aluminum-based part (comprising the aluminum layer and all the layers it bears) of the printing plate from the base layer of the printing plate and thus to recycle each of these parts according to its nature. Therefore, the aluminum part can be recycled as scrap metal and the base part can be recycled as appropriate according to its exact nature.

The base layer can be delaminated from the aluminum layer through chemical or mechanical means depending on the nature of the adhesive.

When a dry adhesive is used, the base layer bearing the dry adhesive compliant layer can be very simply be peeled off the second aluminum oxide layer, which allows delaminating without using any processing liquid. This can be done manually or through with the use of a mechanical peeling device.

When other adhesives are used, the printing plates can be immersed in a processing liquid that will dissolve the adhesive layer. As explained above, this processing liquid can be an alkaline or acidic aqueous solution depending on the solubility of the adhesive, which itself depends on the nature of the developers and fountain solutions used with the printing plate.

It should be noted that whole printing plates can be processed in this was. There is no need to cut them into flakes as the adhesive layer is readily accessible to the processing liquid and there is no seal holding the various layers together.

In embodiments, the processing liquid has a density between that of the base layer and that of aluminum. As a result, the base layer floats at the surface of the processing liquid while the aluminum layer sinks at the bottom of the processing liquid. For note, the density of aluminum itself is about 2.71 g/mL and that of water is 1 mg/mL. In this specific embodiment, the separation of the base layer and the aluminum layer from the processing liquid is easier. For example, the base layer floating on the processing liquid can be separated by overflowing the vessel containing the flakes with more processing liquid, thereby causing the base layer to spill. A net or another suitable means can then be used to catch the base layer. The base layer may also be collected, for instance, by a skimmer. Also, the aluminum layer can be separated from the processing liquid by decantation, filtration or another similar means. In embodiments, this method further comprises the step of drying the base layer and/or the aluminum layer to ease their handling and further recycling.

When a hot-melt adhesive is used, rather than being dissolved in a processing liquid, it can be melted. Then the base layer can be peeled off the aluminum layer. Again, this can be done manually or through with the use of a mechanical peeling device.

After delamination, the base layer and/or the aluminum layer can be recycled according to known methods.

### Definitions

Herein, H1# is a temper designation having its conventional meaning in the art. As such, it convey information about the general manner a metal has been treated and it has specific mechanical properties associated with it. More specifically, "H1" is a temper prefix that applies to products that are only strain hardened to obtain the desired strength without supplementary thermal treatment. It varies from H12 to H18; H12 being quarter-hard and H19 being full-hard.

Herein, alkaline means with a pH greater than 7, preferably between about 9 and about 13, and acidic means with a pH lower than 7, preferably between about 1 and about 4.

Herein, all the thickness values are average values for the whole layer concerned.

The use of the terms "a" and "an" and "the" and similar referents in the context of the disclosure (especially in the context of the following claims) are to be construed to cover both the singular and the plural, unless otherwise indicated herein or clearly contradicted by context.

The terms "comprising", "having", "including", and "containing" are to be construed as open-ended terms (i.e., meaning "including, but not limited to") unless otherwise noted.

Recitation of ranges of values herein are merely intended to serve as a shorthand method of referring individually to each separate value falling within the range, unless otherwise indicated herein, and each separate value is incorporated into the specification as if it were individually recited herein. All subsets of values within the ranges are also incorporated into the specification as if they were individually recited herein.

All methods described herein can be performed in any suitable order unless otherwise indicated herein or otherwise clearly contradicted by context.

The use of any and all examples, or exemplary language (e.g., "such as") provided herein, is intended merely to better illuminate the invention and does not pose a limitation on the scope of the invention unless otherwise claimed.

No language in the specification should be construed as indicating any non-claimed element as essential to the practice of the invention.

Herein, the term "about" has its ordinary meaning. In embodiments, it may mean plus or minus 10% or plus or minus 5% of the numerical value qualified.

Unless otherwise defined, all technical and scientific terms used herein have the same meaning as commonly understood by one of ordinary skill in the art to which this invention belongs.

Other objects, advantages and features of the present invention will become more apparent upon reading of the following non-restrictive description of specific embodiments thereof, given by way of example only with reference to the accompanying drawings.

### DESCRIPTION OF ILLUSTRATIVE EMBODIMENT

The present disclosure is illustrated in further details by the following non-limiting examples.

**Glossary**

| **Term or Acronym** | **Description** |
|---|---|
| Aluminum substrate | Aluminum alloy 1050-H18 with a thickness of 150 µm, available from Sumitomo, Japan |
| Basic Violet 3 | Visible colorant, available from Spectra Colors, Kearny, New Jersey, USA. |
| BOPET base film | Biaxial oriented polyterephthalate film having thickness 120 µm, available from Mylan Optoelectronics, Vietnam |
| CAP | Cellulose acetate phthalate under trade name Eastman C-A-P Cellulose Ester NF, available from Eastman, Kingsport, Tennessee, USA. |
| Dowanol PM | 2-Methoxy propanol, available from Dow Chemicals, USA |
| Elastack® 1000 | Ethylacrylate (0.75)-Methylmethacrylate (0.10)-Acrylic Acid (0.15) copolymer with Tg ∼ 10 °C, which is an alkaline soluble adhesive, available from Mylan Group, |
| Elastack® 1020 | Dimethylaminoethylmethacrylate (0.15)-Ethylacrylate (0.75)-Methylmethacrylate (0.10) copolymer with Tg ∼ 10 °C, which is an acid soluble adhesive, available from Mylan Group, Vietnam. |
| Elastack® R- | Silicone release polyterephthalate coextruded film having a thickness 120 µm, available from |
| PET120 | Mylan Optoelectronics, Vietnam. |
| Elastack® R-PP120 | Silicone release polypropylene coextruded film having a thickness 120 µm, available from Mylan Optoelectronics, Vietnam. |
| GSP85 | Ready to use developer for positive lithographic offset printing plates, available from Mylan Printing Media Corporation, Travinh, Vietnam |
| Lotader® 3210 | Ethylene Acrylic Ester - Maleic Anhydride Terpolymer, available from Arkema, USA |
| MEK | Methyl ethyl ketone, available from BASF, Vietnam |
| P1000S Surfactant | Polysiloxane modified with poly(ethylene oxide) pendant groups, available from American Dye Source, Baie d'Urfe, Quebec, Canada. |
| Paper base | |
| PET base film | Polyterephthalate film coextruded with 20% calcium carbonate particles having thickness 120 µm, available from Mylan Optoelectronics, Vietnam |
| PP base film | Polypropylene film coextruded with 20% calcium carbonate particles having a thickness 120 µm, available from Mylan Optoelectronics, Vietnam |
| PP-D base film | Polypropylene film (120 µm) coextruded with a thin layer of ethylene-butadiene copolymer (20 µm) having hardness of 50 Shore D, available from Mylan Optoelectronics, Vietnam |
| Thermolak® 7525 | Novolac resin, available from Mylan Group, Vietnam |
| Thermolak® 1020M | Near infrared absorbing phenolic resin, available from Mylan Group, Vietnam |
| Thermolak® 1590 | High chemical resistance near infrared absorbing polymer having the following structure, which is available from Mylan Group, Vietnam (wherein the weight percent of the corresponding monomers a/b/c/d/e is 30/48/10/7/5, respectively): |

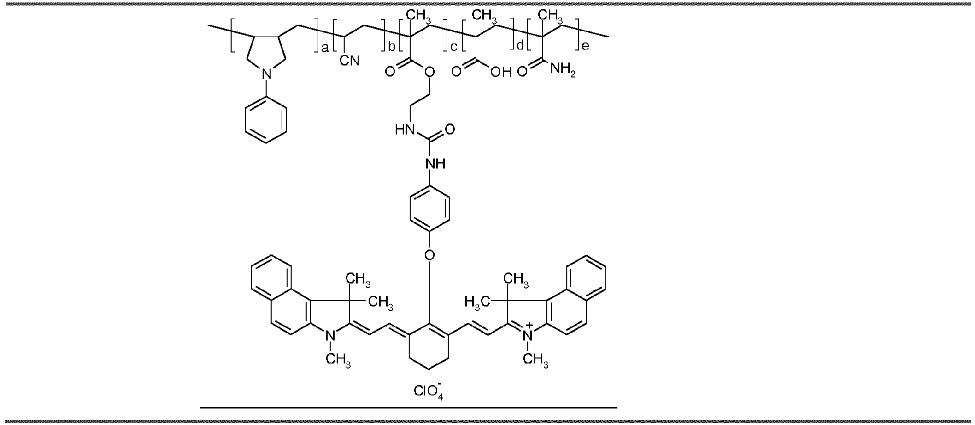

### Example 1 - Positive Printing Plate comprising a Hot-Melt Adhesive and its Mechanical Processing

*Manufacture.* This printing plate was produced following a process similar to that shown in Figure 4. However, there was no coating of a second image layer or overcoat layer. In other words, steps 111 and 112 of Figure 4 were omitted.

An aluminum substrate (see the Glossary above) was subjected to the following electrolytic, coating and drying process:
1) Washing with an aqueous alkaline solution containing sodium hydroxide (3.85 g/l) and sodium gluconate (0.95 g/l) at 65°C;
2) Neutralizing with aqueous hydrochloric acid (2.0 g/l);
3) Washing with water;
4) Electrolytic graining in an aqueous electrolyte containing an aqueous solution of hydrochloric acid (8.0 g/l) and acetic acid (16 g/l), using carbon electrodes at 25°C. The current and charge density were 38.0 A/dm² and 70.0 C/dm², respectively;
5) Desmuting with an aqueous sodium hydroxide solution (2.5 g/l);
6) Neutralizing with an aqueous sulfuric acid solution (2 g/l);
7) Washing with water;
8) Anodizing in an aqueous electrolyte containing sulfuric acid (140 g/l) at 25°C.; the current and charge density were adjusted to produce an aluminum oxide layer having a thickness between 2.5 and 3.0 g/m²;
9) Washing with water;
10) Treating with an aqueous solution containing sodium dihydrophosphate (50 g/l) and sodium fluoride (0.8 g/l) at 75°C;
11) Washing with water at 50°C;
12) Drying with hot air at 110°C;
13) Coating with the solution described below to produce an image forming layer;
14) Drying the image forming layer at a temperature between 100 and 150°C;

The solution coated on the electrolytic treated aluminum web to produce a thermal positive image forming polymeric layer had the following composition:

| **Constituents** | **Weight (Kg)** |
|---|---|
| Thermolak® 7525 | 8.15 |
| Thermolak® 1020M | 1.00 |
| CAP | 0.20 |
| Basic Violet 3 | 0.25 |
| P1000S | 0.40 |
| Dowanol PM | 75.0 |
| MEK | 15.0 |

The coating solution was filtered through a 0.5 µm filter and then coated using a slot-die coating head. The coated web was then dried at 110°C using hot air to give a coating weight of 1.7 g/m².

A PP film base layer was corona treated and then coated with a layer of Lotader® 3210 hot-melt adhesive with a thickness of 20 µm by using a single screw extruder at a temperature 300°C and a speed of 40 RPM with a T-die.

The hot-melt Lotader® 3210 adhesive coated polypropylene base layer was immediately laminated onto the back of the aluminum plate, which was then chilled by a chiller roll at 45°C.

*Use*. After one week storage, the plate was imaged with a plate-setter (PlateRite 8600S, available from Screen, Japan) at an energy density 150 mJ/cm². The imaged plate was developed with GSP85 developer at 24°C and with 20 seconds dwell time using a Tung Sung 88 processor (available from Tung Sung, Malaysia). A clean and high resolution image with 1 to 99% dots was obtained after development. The developed plate was placed on a Heidelberg Quick Master 46 press using VS151 black ink and FS100 fountain solution (available from Mylan Group, Vietnam). The plate produced more than 80,000 copies without noticeable deterioration or reduced resolution of the printed image on the printed sheets. No delamination was observed during imaging, development and printing.

*Mechanical Processing in view of Recycling.* The used plate was then processed for recycling. This was done by passing the used plate through a recycling system first comprising heating rollers at 250°C to melt the adhesive layer. The base layer was then peeled away from the aluminum layer by peel-off rollers.

### Example 2 - Positive Printing Plate comprising a Coated Adhesive and its Chemical Processing Using an Alkaline Media

*Manufacture.* This printing plate was produced following a process similar to that shown in Figure 5. However, there was no coating of a second image layer or overcoat layer. In other words, steps 211 and 212 of Figure 5 were omitted.

The manufacture of this printing plate was similar to that described in Example 1, except for the following. A BOPET base film was corona treated. An adhesive solution containing 5% Elastack® 1000 and 95% Dowanol PM was coated on the BOPET base film using a slot-die coater. This solution was then dried at 120°C using hot air to produce an adhesive layer. The adhesive coated BOPET was then laminated on the back of the aluminum layer.

*Use*. After one week storage, the plate was imaged with a plate-setter (PlateRite 8600S, available from Screen, Japan) at an energy density 150 mJ/cm². The imaged plate was developed with GSP85 developer at 24 °C and with 20 seconds dwell time using a Tung Sung 88 processor (available from Tung Sung, Malaysia). A clean and high resolution image with 1 to 99% dots was obtained after development. The developed plate was placed on a Heidelberg Quick Master 46 press using VS151 black ink and FS100 fountain solution (available from Mylan Group, Vietnam). The plate produced more than 80,000 copies without noticeable deterioration or reduced resolution of the printed image on the printed sheets. No delamination was observed during imaging, development and printing.

*Chemical Processing in view of Recycling.* The separation of the BOPET base layer from the aluminum layer was effected by immersing the used plate into an aqueous solution containing 1M sodium hydroxide at 35°C for 1 hour. The adhesive layer dissolved and the BOPET base film was peeled from the aluminum layer by a home-made mechanical peeling device.

### Example 3 - Positive Printing Plate Comprising a Coated Adhesive and its Chemical Processing Using an Acidic Media

*Manufacture and Use.* This printing plate was identical to that of Example 2 except that Elastack® 1000 was replaced by Elastack® 1020. The obtained printing plate had the same prepress and press characteristics as that described for the printing plate of Example 2. No delamination was observed during imaging, development and printing.

*Chemical Processing in view of Recycling.* The separation of the BOPET base layer from the aluminum layer was effected by immersing the used plate into an aqueous solution containing 1M hydrochloric acid at 35°C for 1 hour. The adhesive layer dissolved and the BOPET base film was peeled from the aluminum layer by a home-made mechanical peeling device.

### Example 4 - Positive Printing Plate Comprising a Coated Adhesive and its Chemical Processing Using an Alkaline Media

A printing plate was produced similarly to Example 2 above, but with the following changes. The base layer was a 130 um BOPET film which was corona treated. It was coated with an adhesive solution, which was a solution of a copolymer of ethyl acrylate (70%), methylmethacrylate (10%) and acrylic acid (20%) in 2-methoxy propanol. The concentration of the polymer was 5% (solid). The copolymer had a T_{g} around 10°C. This copolymer is available from Mylan Group, Vietnam. The adhesive coating was then dried at 130° C. The adhesive layer thus produced was around 20 µm thick.

The obtained printing plate had the same prepress and press characteristics as that described for the printing plate of Example 2. No delamination was observed during imaging, development and printing. The chemical processing was carried out as described in Example 2.

### Example 5 - Positive Printing Plate Comprising a Hot-melt Adhesive and a Silicone Release Base Layer

A printing plate was produced similarly to Example 1 above, except that the base layer was a 120 um Elastack® R-PET120 film, i.e. a base layer including a silicon release layer.

The obtained printing plate had the same prepress and press characteristics as that described for the printing plate of Example 1. No delamination was observed during imaging, development and printing. The separation of the base layer from the aluminum substrate was done by manually peeling off the base layer.

### Example 6 - Positive Printing Plate Comprising a Hot-melt Adhesive and a Silicone Release Base Layer

A printing plate was produced similarly to Example 1 above, except that the base layer was a 120 um Elastack® R-PP120 film, i.e. a base layer including a silicon release layer.

The obtained printing plate had the same prepress and press characteristics as that described for the printing plate of Example 1. No delamination was observed during imaging, development and printing. The separation of the base layer from the aluminum substrate was done by manually peeling off the base layer.

### Example 7 - Positive Printing Plate comprising a Dry Adhesive and its Mechanical Processing

A thermal positive lithographic printing plate with a dry adhesive was produced similarly to that described in Example 1, with the following exceptions.
- The backside of the aluminum web was also electro-grained and anodized to have a surface roughness, Ra = 0.20 µm.
- A PP-D base film (having an ethylene-butadiene copolymer face) was laminated onto the back side of the aluminum sheet.

The plate showed similar prepress and press characteristics as that described in Example 1. No delamination was observed during imaging, development and printing. The PP-D base film was separated from the aluminum layer of the used plate using a mechanical peeling device at room temperature.

### Example 8 - Positive Printing Plate comprising Second Image Forming Layer and a Hot Melt Adhesive

The aluminum treatment was similar to **Example 1**.

A first image forming layer was coated with a solution comprising 8% of Thermolak® 1590, 87% dioxolane and 5% deionized water. The solution was filtered through a 0.5 µm filter and coated on the treated aluminum substrate using a slot-die coating heat. The coating wed was dried at 140 °C using hot air to give a coating weight of 1.0 gram/m².

A second image forming layer was coated onto the first image forming layer using a slot-die coating head. The coating solution had the following composition:

| **Constituents** | **Weight (Kg)** |
|---|---|
| Thermolak® 7525 | 9.35 |
| Thermolak® 1020M | 0.20 |
| CAP | 0.20 |
| Basic Violet 3 | 0.25 |
| P1000S | 0.40 |
| Dowanol PM | 75.0 |
| MEK | 15.0 |

The coated web was then dried at 120°C using hot air to give a coating weight of 1.0 g/m².

A PP film base layer was corona treated and then coated with a layer of Lotader® 3210 hot-melt adhesive with a thickness of 20 µm by using a single screw extruder at a temperature 300°C and a speed of 40 RPM with a T-die.

The Lotader® 3210 hot-melt adhesive coated polypropylene base layer was immediately laminated onto the back of the aluminum plate, which was then chilled by a chiller roll at 45°C.

*Use*. After one week storage, the plate was imaged with a plate-setter (PlateRite 8600S, available from Screen, Japan) at an energy density 150 mJ/cm². The imaged plate was developed with GSP85 developer at 24°C and with 20 seconds dwell time using a Tung Sung 88 processor (available from Tung Sung, Malaysia). A clean and high resolution image with 1 to 99% dots was obtained after development. The developed plate was placed on a Heidelberg Quick Master 46 press using VS151 black ink and FS100 fountain solution (available from Mylan Group, Vietnam). The plate produced more than 80,000 copies without noticeable deterioration or reduced resolution of the printed image on the printed sheets. No delamination was observed during imaging, development and printing.

*Mechanical Processing in view of Recycling*. The used plate was then processed for recycling. This was done by passing the used plate through a recycling system first comprising heating rollers at 250°C to melt the adhesive layer. The base layer was then peeled away from the aluminum layer by peel-off rollers.

The scope of the claims should not be limited by the preferred embodiments set forth in the examples, but should be given the broadest interpretation consistent with the description as a whole.

### References

The present description refers to a number of documents:
- US patent no. 6,124,425;
- US patent no. 6,177,182;
- US patent no. 7,473,515;
- US patent publication no. 2007/0269739;
- US patent publication no. 2008/0171286;
- US patent publication no. 2010/0215944;
- US patent publication no. 2010/0035183;
- US patent publication no. 2011/0277653; and
- International Patent Publication no. WO 2012/155259.

## Claims

1. A laminated lithographic printing plate comprising:
an aluminum layer (14) having a first side and a second side,
a first aluminum oxide layer (16) coating the first side of the aluminum layer,
optionally a second aluminum oxide layer (26) coating the second side of the aluminum layer,
an image forming layer coating the first aluminum oxide layer,
an alkaline soluble or acid soluble adhesive layer (12) adhering to the second side of the aluminum layer (14) or
to said second aluminum oxide layer (26) when said second aluminum oxide layer (26) is present, and
a base layer (10) coating the adhesive layer (12),
the adhesive layer (12) being accessible to and insoluble in:
oleophilic inks, and
an alkaline or acidic aqueous fountain solution used during printing with the printing plate, and
an alkaline or acidic aqueous developer used during development of the printing plate,
while being soluble in an aqueous alkaline or acidic processing liquid to be used for delamination thereby allowing delamination of the printing plate,
wherein when the aqueous fountain solution and aqueous developer are acidic, the aqueous processing liquid is alkaline and the adhesive layer is alkaline soluble and is thus insoluble in the acidic fountain solution and the acidic aqueous developer, while being soluble in the alkaline aqueous processing liquid, and
wherein when the aqueous fountain solution and aqueous developer are alkaline, the aqueous processing liquid is acidic and the adhesive layer (12) is acid soluble and is thus insoluble in the alkaline fountain solution and the alkaline aqueous developer while being soluble in the acidic aqueous processing liquid.

2. The printing plate of claim 1, wherein the aqueous fountain solution and aqueous developer are acidic, the aqueous processing liquid is alkaline and the adhesive layer (12) is alkaline soluble and is thus insoluble in the acidic fountain solution and the acidic aqueous developer, while being soluble in the alkaline aqueous processing liquid.

3. The printing plate of claim 2, wherein the adhesive layer (12) comprises a drying adhesive comprising a polymer having a Tg between about 10 and 60°C and comprising polar functional groups and acidic functional groups.

4. The printing plate of claim 2 or 3, wherein the polymer is an acrylate, urethane, urea, epoxy, or ester polymer.

5. The printing plate of claim 4, wherein the polymer is a copolymer of acrylic acid and one or more alkyl acrylate.

6. The printing plate of claim 5, wherein the copolymer is a copolymer of acrylic acid, methyl acrylate, and ethyl acrylate comprising between about 5 and about 15% by weight methyl acrylate, between about 50 and about 80% by weight ethyl acrylate, and between about 5 and about 20% by weight acrylic acid.

7. The printing plate of claim 1, wherein the aqueous fountain solution and aqueous developer are alkaline, the aqueous processing liquid is acidic and the adhesive layer (12) is acid soluble and is thus insoluble in the alkaline fountain solution and the alkaline aqueous developer while being soluble in the acidic aqueous processing liquid.

8. The printing plate of claim 7, wherein the adhesive layer comprises a drying adhesive comprising a polymer having a Tg between about 10 and 60°C and comprising polar functional groups and basic functional groups.

9. The printing plate of claim 7 or 8, wherein the polymer is an acrylate, urethane, urea, epoxy, or ester polymer.

10. The printing plate of claim 9, wherein the polymer is a copolymer of dialkylamino alkyl acrylate and one or more alkyl acrylate.

11. The printing plate of claim 10, wherein the copolymer is a copolymer of acrylic acid, methyl acrylate, and ethyl acrylate comprising between about 5 and about 15% by weight methyl acrylate, between about 50 and about 80% by weight ethyl acrylate, and between about 5 and about 20% by weight dimethyl amino ethyl acrylate.

12. The printing plate of any one of claims 1 to 11 further comprising a silicon release layer between the base layer (10) and the adhesive layer (12).

13. The printing plate of any one of claims 1 to 12, wherein the base layer is a plastic layer, a composite layer, a cellulose-based layer such as cardstock or paper, or a non-woven fabric layer.

14. The printing plate of any one of claims 1 to 13, wherein the base layer (10) comprises one or more filler.

15. Method of fabricating a laminated lithographic printing plate comprising the steps of :
- providing a lithographic printing plate comprising at least an aluminium layer (14) bearing an image layer;
- providing an alkaline soluble or acid soluble adhesive layer (122) and a base layer (10);
- laminating the base layer on the aluminium layer (14) on the side opposite the image layer, the laminating being carried out through the adhesive layer (12);
wherein the adhesive layer (12) is accessible and is insoluble in:
oleophilic inks, and
an alkaline or acidic aqueous fountain solution used during printing with the printing plate, and
an alkaline or acidic aqueous developer used during development of the printing plate,
while being soluble in an aqueous processing liquid to be used for delamination,
wherein when the aqueous fountain solution and aqueous developer are acidic, the aqueous processing liquid is alkaline and the adhesive layer (12) is alkaline soluble and is thus insoluble in the acidic fountain solution and the acidic aqueous developer, while being soluble in the alkaline aqueous processing liquid, and
wherein when the aqueous fountain solution and aqueous developer are alkaline, the aqueous processing liquid is acidic and the adhesive layer (12) is acid soluble and is thus insoluble in the alkaline fountain solution and the alkaline aqueous developer while being soluble in the acidic aqueous processing liquid.

## Patentansprüche

1. Laminierte lithografische Druckplatte, umfassend:
eine Aluminiumschicht (14) mit einer ersten Seite und einer zweiten Seite,
eine erste Aluminiumoxidschicht (16), die die erste Seite der Aluminiumschicht bedeckt,
optional eine zweite Aluminiumoxidschicht (26), die die zweite Seite der Aluminiumschicht bedeckt,
eine Bilderzeugungsschicht, die die erste Aluminiumoxidschicht bedeckt,
eine alkalilösliche oder säurelösliche Haftschicht (12), die an der zweiten Seite der Aluminiumschicht (14) oder an der zweiten Aluminiumoxidschicht (26) haftet, wenn die zweite Aluminiumoxidschicht (26) vorhanden ist, und
eine Grundschicht (10), die die Klebeschicht (12) beschichtet,
die Klebeschicht (12) ist zugänglich und unlöslich in:
oleophilen Tinten und
einem alkalischen oder sauren wässrigen Feuchtmittel, das während des Druckens mit der Druckplatte verwendet wird, und
einem alkalischen oder saurem wässrigem Entwickler, der während der Entwicklung der Druckplatte verwendet wird,
während sie in einer wässrigen alkalischen oder sauren Verarbeitungsflüssigkeit löslich ist, die zur Delaminierung verwendet werden soll, wodurch eine Delaminierung der Druckplatte ermöglicht wird,
wobei, wenn das wässrige Feuchtmittel und der wässrige Entwickler sauer sind, die wässrige Verarbeitungsflüssigkeit alkalisch ist und die Klebeschicht alkalisch löslich ist und somit in dem sauren Feuchtmittel und dem sauren wässrigen Entwickler unlöslich ist, während sie in der alkalischen wässrigen Verarbeitungsflüssigkeit löslich ist, und
wenn das wässrige Feuchtmittel und der wässrige Entwickler alkalisch sind, die wässrige Verarbeitungsflüssigkeit sauer ist und die Klebeschicht (12) säurelöslich ist und somit in dem alkalischen Feuchtmittel und dem alkalischen wässrigen Entwickler unlöslich ist, während sie in der sauren wässrigen Verarbeitungsflüssigkeit löslich ist.

2. Die Druckplatte nach Patentanspruch 1, wobei das wässrige Feuchtmittel und der wässrige Entwickler sauer sind, die wässrige Verarbeitungsflüssigkeit alkalisch ist und die Klebeschicht (12) alkalisch löslich ist und somit in dem sauren Feuchtmittel und dem sauren wässrigen Entwickler unlöslich ist, während sie in der alkalischen wässrigen Verarbeitungsflüssigkeit löslich ist.

3. Die Druckplatte nach Patentanspruch 2, wobei die Klebeschicht (12) einen trockenen Klebstoff umfasst, der ein Polymer mit einer Tg zwischen etwa 10 und 60°C umfasst und polare funktionelle Gruppen und saure funktionelle Gruppen umfasst.

4. Die Druckplatte nach Patentanspruch 2 oder 3, wobei das Polymer ein Acrylat-, Urethan-, Harnstoff-, Epoxid- oder Esterpolymer ist.

5. Die Druckplatte nach Patentanspruch 4, wobei das Polymer ein Copolymer aus Acrylsäure und einem oder mehreren Alkylacrylaten ist.

6. Die Druckplatte nach Patentanspruch 5, wobei das Copolymer ein Copolymer aus Acrylsäure, Methylacrylat und Ethylacrylat ist, das zwischen etwa 5 und etwa 15 Gew.-% Methylacrylat, zwischen etwa 50 und etwa 80 Gew.-% Ethylacrylat und zwischen etwa 5 und etwa 20 Gew.-% Acrylsäure umfasst.

7. Die Druckplatte nach Patentanspruch 1, wobei das wässrige Feuchtmittel und der wässrige Entwickler alkalisch sind, die wässrige Verarbeitungsflüssigkeit sauer ist und die Klebeschicht (12) säurelöslich ist und somit in dem alkalischen Feuchtmittel und dem alkalischen wässrigen Entwickler unlöslich ist, während sie in der sauren wässrigen Verarbeitungsflüssigkeit löslich ist.

8. Die Druckplatte nach Patentanspruch 7, wobei die Klebeschicht einen trocknenden Klebstoff umfasst, der ein Polymer mit einer Tg zwischen etwa 10 und 60 °C umfasst und polare funktionelle Gruppen sowie basische funktionelle Gruppen umfasst.

9. Die Druckplatte nach Patentanspruch 7 oder 8, wobei das Polymer ein Acrylat-, Urethan-, Harnstoff-, Epoxid- oder Esterpolymer ist.

10. Die Druckplatte nach Patentanspruch 9, wobei das Polymer ein Copolymer aus Dialkylaminoalkylacrylat und einem oder mehreren Alkylacrylaten ist.

11. Die Druckplatte nach Patentanspruch 10, wobei das Copolymer ein Copolymer aus Acrylsäure, Methylacrylat und Ethylacrylat ist, das zwischen etwa 5 und etwa 15 Gew.-% Methylacrylat, zwischen etwa 50 und etwa 80 Gew.-% Ethylacrylat und zwischen etwa 5 und etwa 20 Gew.-% Dimethylaminoethylacrylat umfasst.

12. Die Druckplatte nach einem der Patentansprüche 1 bis 11, ferner umfassend eine Silikontrennschicht zwischen der Basisschicht (10) und der Klebeschicht (12) .

13. Die Druckplatte nach einem der Patentansprüche 1 bis 12, wobei die Basisschicht eine Kunststoffschicht, eine Verbundschicht, eine Schicht auf Zellulosebasis, wie beispielsweise Karton oder Papier, oder eine Vliesschicht ist.

14. Die Druckplatte nach einem der Patentansprüche 1 bis 13, wobei die Basisschicht (10) einen oder mehrere Füllstoffe umfasst.

15. Methode zur Herstellung einer laminierten lithografischen Druckplatte, umfassend die Schritte von:
- Bereitstellen einer lithografischen Druckplatte, die mindestens eine Aluminiumschicht (14) umfasst, die eine Bildschicht trägt;
- Bereitstellen einer alkalisch löslichen oder säurelöslichen Klebeschicht (122) und einer Basisschicht (10);
- Laminieren der Basisschicht auf der Aluminiumschicht (14) auf der der Bildschicht der gegenüberliegenden Seite, wobei das Laminieren durch die Klebeschicht (12) hindurch erfolgt;
wobei die Klebeschicht (12) zugänglich ist und unlöslich ist in:
oleophilen Tinten und
einem alkalischen oder sauren wässrigen Feuchtmittel, das während des Druckens mit der Druckplatte verwendet wird, und
einem alkalischen oder saurem wässrigem Entwickler, der während der Entwicklung der Druckplatte verwendet wird,
während sie in einer wässrigen Verarbeitungsflüssigkeit löslich ist, die zur Delaminierung verwendet werden soll,
wobei, wenn das wässrige Feuchtwasser und der wässrige Entwickler sauer sind, die wässrige Verarbeitungsflüssigkeit alkalisch ist und die Klebeschicht (12) alkalisch löslich ist und somit in dem sauren Feuchtwasser und dem sauren wässrigen Entwickler unlöslich ist, während sie in der alkalischen wässrigen Verarbeitungsflüssigkeit löslich ist, und
wenn das wässrige Feuchtmittel und der wässrige Entwickler alkalisch sind, die wässrige Verarbeitungsflüssigkeit sauer ist und die Klebeschicht (12) säurelöslich ist und somit in dem alkalischen Feuchtmittel und dem alkalischen wässrigen Entwickler unlöslich ist, während sie in der sauren wässrigen Verarbeitungsflüssigkeit löslich ist.

## Revendications

1. Plaque d'impression lithographique stratifiée comprenant :
une couche d'aluminium (14) ayant un premier côté et un second côté,
une première couche d'oxyde d'aluminium (16) recouvrant le premier côté de la couche d'aluminium,
éventuellement une seconde couche d'oxyde d'aluminium (26) recouvrant le second côté de la couche d'aluminium,
une couche formant image recouvrant la première couche d'oxyde d'aluminium,
une couche adhésive alcalino-soluble ou acido-soluble (12) adhérant au second côté de la couche d'aluminium (14) ou à ladite seconde couche d'oxyde d'aluminium (26) lorsque ladite seconde couche d'oxyde d'aluminium (26) est présente, et
une couche de base (10) recouvrant la couche adhésive (12),
la couche adhésive (12) étant accessible à, et insoluble dans :
les encres oléophiles, et
une solution de mouillage aqueuse alcaline ou acide utilisée pendant l'impression avec la plaque d'impression, et
un révélateur aqueux alcalin ou acide utilisé pendant le développement de la plaque d'impression,
tout en étant soluble dans un liquide de traitement aqueux alcalin ou acide destiné à être utilisé pour le délaminage, en permettant ainsi le délaminage de la plaque d'impression,
dans laquelle, lorsque la solution de mouillage aqueuse et le révélateur aqueux sont acides, le liquide de traitement aqueux est alcalin et la couche adhésive est alcalino-soluble et est ainsi insoluble dans la solution de mouillage acide et le révélateur aqueux acide, tout en étant soluble dans le liquide de traitement aqueux alcalin, et
dans laquelle, lorsque la solution de mouillage aqueuse et le révélateur aqueux sont alcalins, le liquide de traitement aqueux est acide et la couche adhésive (12) est acido-soluble et est ainsi insoluble dans la solution de mouillage alcaline et le révélateur aqueux alcalin, tout en étant soluble dans le liquide de traitement aqueux acide.

2. Plaque d'impression selon la revendication 1, dans laquelle la solution de mouillage aqueuse et le révélateur aqueux sont acides, le liquide de traitement aqueux est alcalin et la couche adhésive (12) est alcalino-soluble et est ainsi insoluble dans la solution de mouillage acide et le révélateur aqueux acide, tout en étant soluble dans le liquide de traitement aqueux alcalin.

3. Plaque d'impression selon la revendication 2, dans laquelle la couche adhésive (12) comprend un adhésif séchant comprenant un polymère ayant un Tg compris entre environ 10 et 60 °C et comprenant des groupes fonctionnels polaires et des groupes fonctionnels acides.

4. Plaque d'impression selon la revendication 2 ou 3, dans laquelle le polymère est un polymère d'acrylate, d'uréthane, d'urée, d'époxy ou d'ester.

5. Plaque d'impression selon la revendication 4, dans laquelle le polymère est un copolymère d'acide acrylique et d'un ou plusieurs acrylate(s) d'alkyle.

6. Plaque d'impression selon la revendication 5, dans laquelle le copolymère est un copolymère d'acide acrylique, d'acrylate de méthyle, et d'acrylate d'éthyle comprenant entre environ 5 et environ 15 % en poids d'acrylate de méthyle, entre environ 50 et environ 80 % en poids d'acrylate d'éthyle et entre environ 5 et environ 20 % en poids d'acide acrylique.

7. Plaque d'impression selon la revendication 1, dans laquelle la solution de mouillage aqueuse et le révélateur aqueux sont alcalins, le liquide de traitement aqueux est acide et la couche adhésive (12) est acido-soluble et est donc insoluble dans la solution de mouillage alcaline et le révélateur aqueux alcalin tout en étant soluble dans le liquide de traitement aqueux acide.

8. Plaque d'impression selon la revendication 7, dans laquelle la couche adhésive comprend un adhésif séchant comprenant un polymère ayant un Tg compris entre environ 10 et 60 °C et comprenant des groupes fonctionnels polaires et des groupes fonctionnels basiques.

9. Plaque d'impression selon la revendication 7 ou 8, dans laquelle le polymère est un polymère d'acrylate, d'uréthane, d'urée, d'époxy ou d'ester.

10. Plaque d'impression selon la revendication 9, dans laquelle le polymère est un copolymère d'acrylate dialkylamino-alkyle et un ou plusieurs acrylate(s) d'alkyle.

11. Plaque d'impression selon la revendication 10, dans laquelle le copolymère est un copolymère d'acide acrylique, d'acrylate de méthyle et d'acrylate d'éthyle, comprenant entre environ 5 et environ 15 % en poids d'acrylate de méthyle, entre environ 50 et environ 80 % en poids d'acrylate d'éthyle, et entre environ 5 et environ 20 % en poids d'acrylate de diméthyle amino éthyle.

12. Plaque d'impression selon l'une quelconque des revendications 1 à 11, comprenant en outre une couche antiadhésive de silicium entre la couche de base (10) et la couche adhésive (12).

13. Plaque d'impression selon l'une quelconque des revendications 1 à 12, dans laquelle la couche de base est une couche de plastique, une couche de composite, une couche à base de cellulose telle que du carton ou du papier, ou une couche de tissu non tissé.

14. Plaque d'impression lithographique selon l'une quelconque des revendications 1 à 13, dans laquelle la couche de base (110) comprend une ou plusieurs charge(s).

15. Procédé de fabrication d'une plaque d'impression lithographique stratifiée comprenant les étapes consistant à :
• fournir une plaque d'impression lithographique comprenant au moins une couche d'aluminium (14) portant une couche formant image ;
• fournir une couche adhésive acido-soluble ou alcalino-soluble (122) et une couche de base (10) ;
• stratifier la couche de base sur la couche d'aluminium (14) sur le côté opposé à la couche formant image, le laminage étant effectué à travers la couche adhésive (12) ;
dans lequel la couche adhésive (12) est accessible et est insoluble dans :
les encres oléophiles, et
une solution de mouillage aqueuse acide ou alcaline utilisée pendant l'impression avec la plaque d'impression, et
un révélateur aqueux acide ou alcalin utilisé pendant le développement de la plaque d'impression,
tout en étant soluble dans un liquide de traitement aqueux destiné à être utilisé pour le délaminage,
dans lequel, lorsque la solution de mouillage aqueuse et le révélateur aqueux sont acides, le liquide de traitement aqueux est alcalin et la couche adhésive (12) est alcalino-soluble et est ainsi insoluble dans la solution de mouillage acide et dans le révélateur aqueux acide, tout en étant soluble dans le liquide de traitement aqueux alcalin et
dans lequel, lorsque la solution de mouillage aqueuse et le révélateur aqueux sont alcalins, le liquide de traitement aqueux est acide et la couche adhésive (12) est acido-soluble et est ainsi insoluble dans la solution de mouillage alcaline et dans le révélateur aqueux alcalin, tout en étant soluble dans le liquide de traitement aqueux acide.
